Europäisches Patentamt

European Patent Office

Office européen des brevets

(19)

(11) **EP 0 740 410 B1**

(12) **EUROPEAN PATENT SPECIFICATION**

(45) Date of publication and mention
of the grant of the patent:
**24.10.2001 Bulletin 2001/43**

(51) Int Cl.$^7$: **H03G 5/02**

(21) Application number: **96302834.5**

(22) Date of filing: **23.04.1996**

(54) **Sound quality control system**

System zum Einstellen der Tonqualität

Système pour commander la qualité du son

(84) Designated Contracting States:
**DE FR GB NL**

(30) Priority: **25.04.1995 JP 12597795**
**03.08.1995 JP 19852095**

(43) Date of publication of application:
**30.10.1996 Bulletin 1996/44**

(73) Proprietor: **MATSUSHITA ELECTRIC INDUSTRIAL
CO., LTD.
Kadoma-shi, Osaka 571-8501 (JP)**

(72) Inventors:
• **Tagami, Ryo**
**Katano-shi, Osaka 576 (JP)**
• **Serikawa, Mitsuhiko**
**Nishinomiya-shi, Hogo 663 (JP)**

(74) Representative: **Crawford, Andrew Birkby et al
A.A. Thornton & Co.
235 High Holborn
London WC1V 7LE (GB)**

(56) References cited:
**EP-A- 0 347 719        EP-A- 0 404 474
DE-A- 4 121 628        US-A- 5 045 802**

**Description**

FIELD OF THE INVENTION

The present invention relates to a sound quality control system for controlling the sound quality of a sound reproduction apparatus.

BACKGROUND OF THE INVENTION

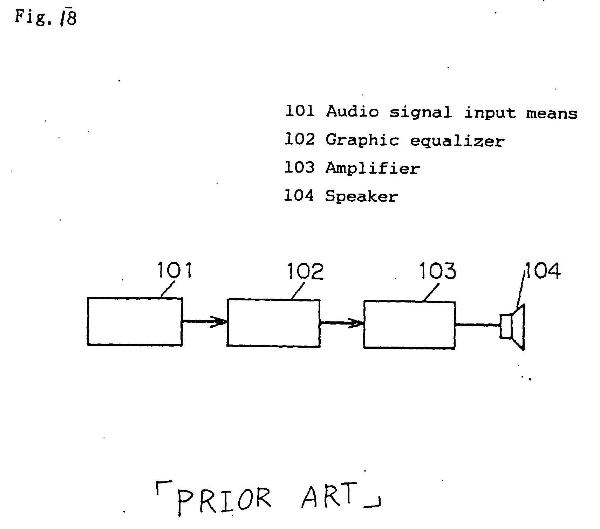

Sound reproduction apparatus having a built-in control means for raising or lowering the gains in bass/treble or some other frequency range, called tone control or graphic equalizer has been developed and is in use. Recently, a "pre-set menu" type equalizer adjusted to be suitable to a specific music genre, such as n jazz", "pop music", "classical music", etc. is also available. In the following, description is made of a prior art sound quality control system referring to Fig.18.

Fig.18 shows a constitution of a prior art sound quality control system. In Fig.18, an audio signal inputted to an audio signal input means 101 is adjusted in gain at each frequency range by a graphic equalizer 102. The signal thus adjusted is amplified by an amplifier 103 and reproduced through a loudspeaker 104. A general arrangement of the frequency range for adjustment is an interval of one octave; for example, 32Hz, 63Hz, 125Hz, 250Hz, 500Hz, 1KHz, 2KHz, 4KHz, 8KHz, 16KHz. A listener has to adjust the gains at each respective frequency range by hand on the graphic equalizer, in order to obtain a sound reproduction of his choice.

Graphic equalizer 102 is usually comprised of analog circuits; however, the same characteristics are implementable with an IIR(infinite impulse response) filter or a FIR(finite impulse response) filter using digital circuits.

As described above, the listener adjusts the sound quality by compensating the gains of each frequency range using a graphic equalizer. Or, by using a sound quality control system called a tone control, instead of using a graphic equalizer.

In a conventional method using a graphic equalizer or tone control, however, the sound quality of reproduced sound can be modified but a listener is often faced with difficulty in finding out how to adjust for implementing a desired sound quality.

Most listeners are not knowledgeable about to what extent the gains of each respective frequency range should be adjusted to produce e.g. a "soft" sound. And quite a long time has to be spent to reach a desired sound quality. This is because what listeners request is something psychological, e.g. soft sound, powerful sound, clear sound, while conventional graphic equalizers simply offer something physical, e.g. 3dB enhancement at 500Hz, 4dB attenuation at 4KHz; and the counter-relationship between the two has not been made known.

As an example of the prior art, EP 0347719-A discloses a graphic equalizer system as mentioned above, having preset equalizer configurations stored in a memory provided therein. Spatial configurations are stored as well as music genre configurations and a combination characteristic consisting of a summation of a spatial configuration characteristic and a genre configuration characteristic is generated dependent upon the selected music genre and spatial genre.

SUMMARY OF THE INVENTION

The object of the present invention is to offer a sound quality control system that precisely implements a quality of sound desired by a listener in a simple manner.

According to the present invention, there is provided a sound quality control system arranged to control the frequency spectrum of an audio input signal to obtain one or more user-defined subjective sound qualities upon reproduction of said signal in a sound reproduction apparatus, said sound quality control system comprising:

modelling means for mapping one or more user-defined subjective quantitative values which each correspond to the respective one or more user-defined subjective sound qualities to a plurality of characteristic physical quantities which correspond to a respective plurality of frequency bands within a predetermined frequency range of the sound reproduction apparatus, said modelling means further comprising:

physical quantity input means for inputting the characteristic physical quantities for the sound reproduction apparatus;

psychological quantity input means for inputting said one or more user-defined subjective quantitative values based on listener responses to a sound reproduced by the sound reproduction apparatus;

correlation coefficient calculation means for calculating a plurality of correlation coefficients between said characteristic physical quantities and said user-defined subjective quantitative values; and

counter-model calculation means for calculating a quantitative counter-relationship between said characteristic physical quantities and said user-defined subjective quantitative values based on the calculated correlation coefficients;

and wherein said sound quality control system further comprises:

compensation characteristic extracting means for generating a frequency compensation characteristic based on said quantitative counter-relationship; and

signal processing means for processing the frequency spectrum of the audio input signal in accordance with said frequency compensation characteristic.

According to a second aspect of the present invention, there is further provided sound quality control system arranged to control the frequency spectrum of an audio input signal to obtain one or more user-defined subjective sound qualities upon reproduction of said audio input signal in a sound reproduction apparatus, said sound quality control system comprising:

an audio signal input means;

a sound quality input means arranged to allow a user to input a desired quantitative sound quality value according to a sound quality scale;

a sound quality display means for displaying said inputted sound quality value on a real-time basis;

a compensation characteristic extracting means for generating a frequency compensation characteristic corresponding to the inputted sound quality value using a pre-calculated quantitative counter relationship between a plurality of characteristic physical quantities which correspond to a respective plurality of frequency bands within a predetermined frequency range of the sound reproduction apparatus and one or more listener-defined subjective quantitative values which each correspond to the respective one or more user-defined subjective sound qualities; and

a sound quality control means including a signal processing means for processing the frequency spectrum of the audio input signal in accordance with said frequency compensation characteristic.

From a further aspect, there is also provided a sound quality control system arranged to control the frequency spectrum of an audio input signal to adjust one or more user-defined subjective sound qualities upon reproduction of said audio input signal in a sound reproduction apparatus, said sound quality control system comprising:

a compensation characteristic input means for inputting a compensation characteristic used to adjust the audio input signal;

a compensation characteristic memory section for recording said inputted compensation characteristic;

a compensation characteristic selection means for selecting a recorded compensation characteristic from said memory section;

sound quality control means for receiving said audio input signal and controlling the frequency spectrum of said signal to adjust said signal;

control means for controlling the sound quality control means based on an output of said compensation selection means;

sound quality calculation means for calculating one or more quantitative sound quality values respectively indicative of the user-defined subjective sound qualities based on data of said selected compensation characteristic and using a pre-calculated quantitative counter-relationship between a plurality of characteristic physical quantities which correspond to a respective plurality of frequency bands within a predetermined frequency range of the sound reproduction apparatus and one or more listener-defined subjective quantitative values which each correspond to the respective one or more user defined subjective sound qualities; and

sound quality display means for displaying said calculated quantitative sound quality values.

Furthermore, from yet another aspect, the present invention also provides a sound quality modelling method for quantitatively modelling a relationship between one or more user-defined subjective sound qualities and a plurality of characteristic physical quantities relating to the sound produced by reproducing an audio input signal in a sound reproduction apparatus, said method comprising the steps of:-

reproducing the audio input signal in the sound reproduction apparatus;

varying the plurality of characteristic physical quantities relating to the produced sound wherein said quantities correspond to a respective plurality of frequency bands within a predetermined frequency range of the second reproduction apparatus;

evaluating listener responses to the produced sound using a quantitative sound quality scale to obtain one or more user-defined subjective quantitative values each relating to a respective user-defined subjective sound quality; correlating said user-defined subjective quantitative values with said plurality of characteristic physical quantities for each band to obtain a plurality of correlation coefficients; and

calculating a quantitative counter-relationship between said characteristic physical quantities and said user-defined subjective quantitative values based on the calculated plurality of correlation coefficients.

With the above described constitutions, the present invention precisely realizes a desired sound quality, because control is performed based on a quantitative counter-relationship model between the physical characteristic (physical quantity) of a sound reproduction apparatus and the psychological characteristic (psychological quantity).

A highly precise counter-relation model can be constituted if a sound pressure frequency characteristic most influential to the sound quality is used as the physical quantity of the quantitative counter model.

Further, a desired sound quality can be realized precisely and swiftly if a compensation characteristic based on the quantitative counter model and the corresponding psychological quantity are recorded as a pair in the memory section.

Further, a desired sound quality can be realized more precisely if an interpolation is conducted using a plurality of compensation characteristics.

A listener is not requested to control physical characteristics in controlling sound quality; by a simple operation of inputting a desired sound quality, the sound quality is realized precisely and swiftly.

Further, by recording an inputted sound quality in the memory section, a sound quality once realized in the past can be reproduced again by a simple operation.

Further, by the display of a compensation characteristic for realizing an inputted sound quality, the psychological effect regarding the sound quality control is enhanced by the visual effect.

When controlling the physical characteristic, like the case with a conventional graphic equalizer, the present control system calculates a sound quality of the time and displays it on a real-time basis; this helps realize a desired sound quality within a short time span.

BRIEF DESCRIPTION OF THE DRAWINGS

Fig. 1 is a block diagram showing the basic constitution of a sound quality control system according to a first embodiment of the present invention.

Fig.2 is a block diagram showing the basic constitution of a model constituting means provided in a sound quality control system of the first embodiment.

Fig.3 explains a sound quality appraisal sheet by way of adjectives of sound quality.

Fig.4 shows an exemplary correlation coefficient of physical characteristics to each of the adjectives of sound quality.

Fig.5 shows an exemplary regression coefficient to each of the adjectives of sound quality.

Fig.6 shows an exemplary result of a calculation by the counter model calculation means of the first embodiment.

Fig.7 is a block diagram showing the basic constitution of a first compensation characteristics extracting means provided in a sound quality control system of the first embodiment.

Fig.8 is a block diagram showing the basic constitution of a second compensation characteristics extracting means provided in a sound quality control system of the first embodiment.

Fig.9 is a block diagram showing the basic constitution of a third compensation characteristics extracting means provided in a sound quality control system of the first embodiment.

Fig.10 is a block diagram showing the basic constitution of a sound quality control system according to a second embodiment of the present invention.

Fig.11 shows an example of a psychological category.

Fig.12 shows an example of a sound quality display means.

Fig.13 shows an example of a sound quality input means.

Fig.14 shows an example of a sound quality display means.

Fig.15 is a block diagram showing the basic constitution of a sound quality control system according to a third embodiment of the present invention.

Fig.16 is a block diagram showing the basic constitution of a sound quality control system according to a fourth embodiment of the present invention.

Fig.17 is a block diagram showing the basic constitution of a sound quality control system according to a fifth embodiment of the present invention.

Fig.18 is a block diagram showing the basic constitution of a prior art sound quality control system.

DESCRIPTION OF THE PREFERRED EMBODIMENTS

In the following, a first embodiment of the present invention is described referring to the accompanying Figures.

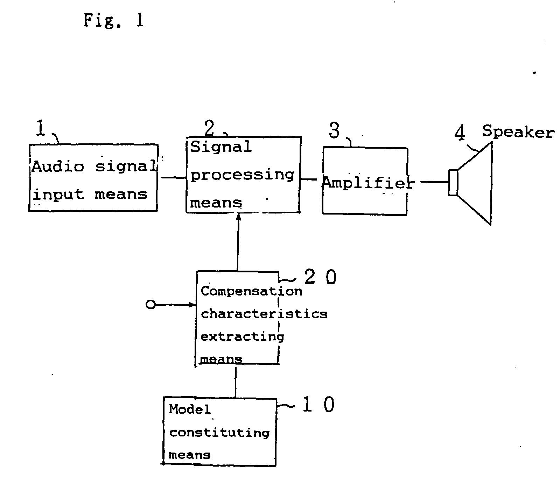

Fig. 1 is a block diagram showing the basic constitution of a sound quality control system according to a first embodiment of the present invention. In Fig.1, numeral 1 denotes an audio signal input means, 2 a signal processing means, 3 an amplifier, 4 a loudspeaker, 10 a model constituting means, and 20 a compensation characteristics extracting means.

In the model constituting means 10, a quantitative counter model between the physical characteristic of a sound reproduction apparatus and a plurality of psychological quantities (impressions) inspired in a listener upon hearing (listening) a sound therefrom is constituted. The counter model is a relationship between the psychological quantity and the physical quantity expressed in numerical formula and which is constituted for each psychological quantity.

Based on the quantitative counter model, a desired sound quality is inputted to compensation characteristics extracting means 20, and compensation characteristics extracting means 20 extracts a compensation characteristic for realizing the desired sound quality. The compensation characteristic thus extracted by the compensation characteristics extracting means 20 is set to the signal processing means 2, an audio signal inputted from the audio signal input means 1 is processed according to the compensation characteristic set to the signal processing means 2, and then reproduced through amplifier 3 by loudspeaker 4. In most of the cases, the signal processing means 2 is comprised of a graphic equalizer of analog circuit; however, a same effect is obtainable by the use of a digital circuit IIR type filter, or FIR type filter.

As described above, by controlling sound quality using a compensation characteristic which is based on a quantitative counter model between the physical quantity and the psychological quantity, a sound quality desired by a listener is precisely reproduced.

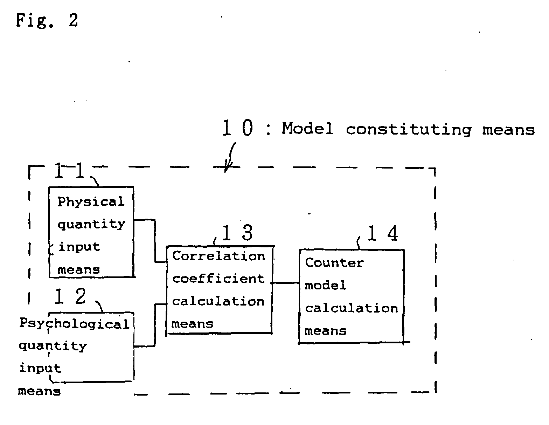

Next, model constituting means 10 is described in more detail. Fig.2 is a block diagram showing the basic constitution of model constituting means 10.

Numeral 11 denotes a physical quantity input means, 12 a psychological quantity input means, 13 a correlation coefficient calculation means, 14 a counter model calculation means.

In the physical quantity input means 11, various sound pressure frequency characteristics of a plurality of sound reproduction apparatuses are inputted. Here, a frequency range from 20Hz to 20KHz is divided into n frequency bands (in this case, 10 bands), and the difference of the level of each frequency band from the mean sound pressure level, which is a value corresponding to the total sum of the sound pressures of all the frequency bands divided by n, (hereinafter referred to as the deviation level) is inputted together with the absolute values.

Here, the level differences in the frequency bands, with 32Hz, 64Hz, 125Hz, 250Hz, 500Hz, 1KHz, 2KHz, 4KHz, 8KHz, 16KHz as the centre frequency of each respective band, are inputted together with the absolute values thereof, totalling 20 kinds of physical quantities. The number and the centre frequency of dividing a frequency range are not limited to those exemplified here.

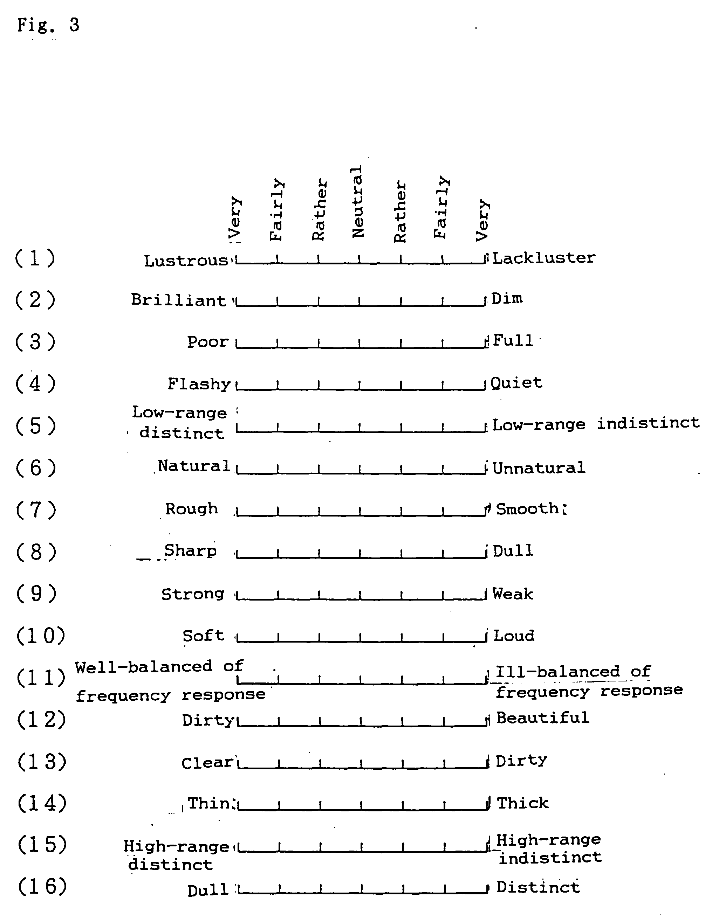

Meanwhile, psychological quantity input means 12 inputs a psychological quantity felt by a listener upon listening to a sound reproduction apparatus having a physical characteristic inputted in physical quantity input means 11. Fig.3 shows example of an appraisal sheet for the evaluation by listeners; here, evaluation by a 7-step SD (semantic differential) method is prepared for 16 pairs of adjectives of sound quality. The SD method is an evaluation method in which a scale between a pair of adjectives with opposite meanings but relating to the same particular sound quality is graded into several steps with semantic words (eg. very flashy, fairly flashy, rather flashy, neutral, rather quiet, fairly quiet, very quiet ).

Each of the seven evaluation steps is given with marks from 1 to 7, and an evaluated mark is inputted to psychological quantity input means 12. (Hereinafter, the scales shown in Fig.3 are referred to as psychological category scale.) When there are plural evaluaters, a general practice is to input their mean value.

Although the number of categories of the psychological quantity is made to be 16 here, the number may be either more or smaller. Besides the above, a factor of sound quality extracted from a result obtained through appraisal with plural pairs of adjectives of sound quality and by applying to the result a factor analysis method may be used as the psychological category scale; and a result of listening evaluation with the scale may be inputted to psychological quantity input means 12. The factor analysis method is a method of statistical processing, with which those adjectives of sound quality having similar meanings are integrated into a single result factor, and as a result factors of sound quality independent to each other can be extracted. Thus, when factors of sound quality obtained through factor analysis are used, the number of psychological quantities to be inputted to the psychological quantity input means 12 decreases, and the burden of listening appraisal is lowered.

By applying factor analysis, adjectives of sound quality such as flashy-quiet, high frequency range distinct-high frequency range indistinct, dull-distinct, sharp-dull, brilliant-dim, clear-dirty, lustrous-lackluster, etc. are integrated into a single "clarity" factor; low frequency range distinct-low frequency range indistinct, thin-thick, poor-full, strong-weak, soft-loud, etc. into a "powerfulness" factor; and natural-unnatural, frequency response well-balanced-frequency response ill-balanced, rough-smooth, dirty-beautiful, etc. into a "beauty" factor.

The plural physical quantities and psychological quantities inputted at physical quantity input means 11 and psychological quantity input means 12 are calculated by correlation coefficient calculation means 13 to obtain a correlation coefficient between the two. Here, the correlation coefficient between each respective adjective of sound quality and physical quantity of each frequency band is calculated. From the results, a certain frequency band which gives influence to an adjective of sound quality becomes known, and a rough correlationship can be expressed with the correlation coefficient.

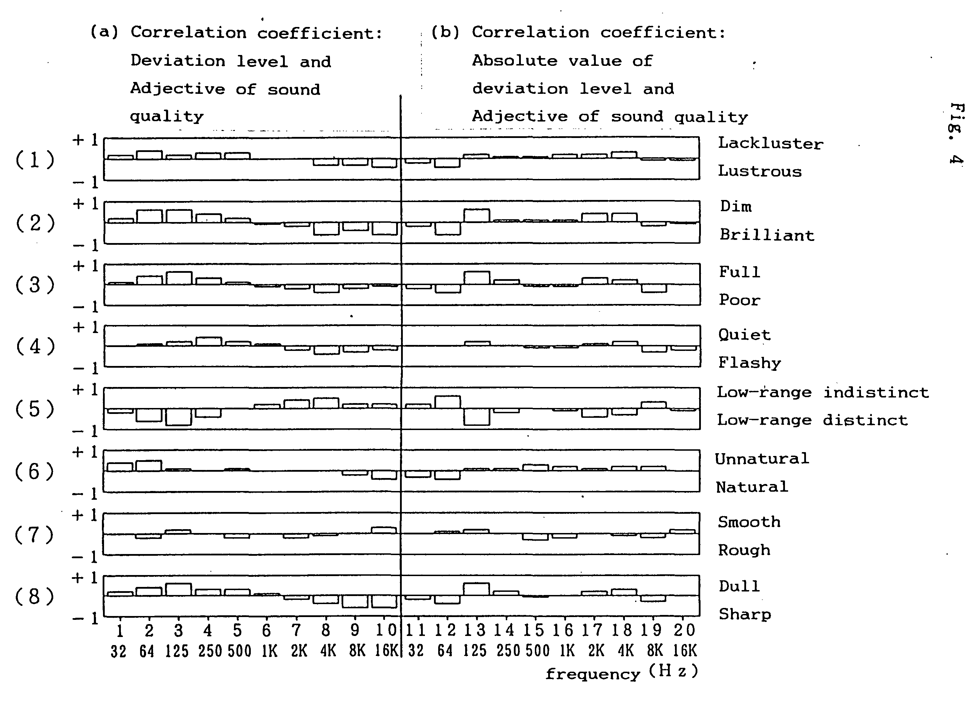

Fig.4 shows an example of data analysed in each frequency band for the correlation coefficient at each respective adjective of sound quality. Numerals 1 - 10 and 11 - 20 on the horizontal axis indicate frequency bands. Values on the vertical axis for 1 - 10 indicate the correlation coefficient between the deviation level and the psychological quantity of each adjective of sound quality in frequency bands having the centre frequency of each respective band at 32Hz, 64Hz, 125Hz, 250Hz, 500Hz, 1KHz, 2KHz, 4KHz, 8KHz, and 16KHz. Likewise, values on the vertical axis for 11 - 20 indicate the correlation coefficient between the absolute value of deviation level and the psychological quantity of each adjective of sound quality in frequency bands having the centre frequency of each respective band at 32Hz, 64Hz, 125Hz, 250Hz, 500Hz, 1KHz, 2KHz, 4KHz, 8KHz, and 16KHz.

The counter model calculation means 14 shown in Fig.2 is a means for calculating a quantitative counter model between the physical quantity and the psychological quantity using the above correlation coefficient. In this quantitative counter model, the psychological quantity Z becomes a regression formula represented as linear primary unification of the physical quantity X; where the deviation level or the absolute value in each frequency band is treated as the physical quantity X. A general formula of this regression formula is shown as the following formula (1):

$$Z = a_0 + a_1 X_1 + a_2 X_2 + \cdots + a_i X_i \tag{1}$$

In the counter model calculation means 14, the regression constant column $a_0$ in formula (1) and the regression coefficient $a_i$ to the physical quantity at band i are calculated, where i corresponds to the number of the frequency band. In this way, a quantitative counter model as represented by the regression formula (1) is constituted from the pluralities of physical quantities and psychological quantities inputted.

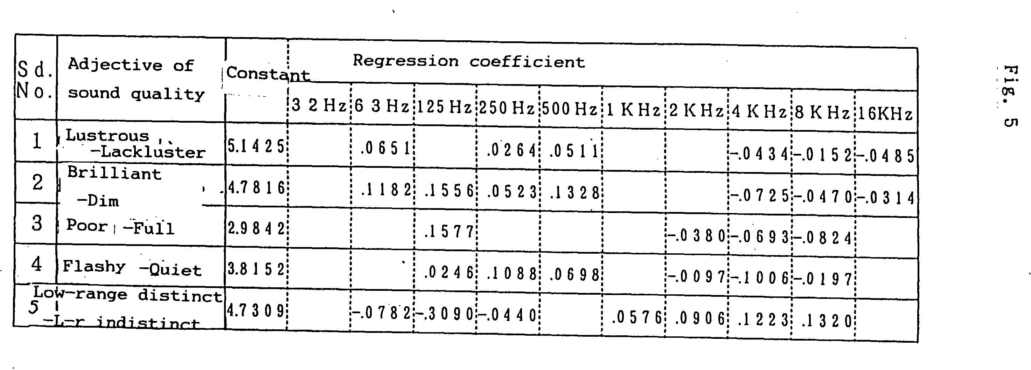

Fig.5 shows an example table of coefficients used for the regression formula. On each line of Fig.5, a pair of adjectives of sound quality are described, followed by the constant column and the regression coefficient at each frequency band. For example, in item (5) "Low frequency range distinct-indistinct", the coefficient value is the largest in negative at 125Hz, and each of the coefficients from 63Hz to 250Hz is negative. This means that in the psychological quantity n low frequency range indistinct", the elements in 63Hz - 250Hz bear the negative correlationship. This is because of a fact explained earlier with respect to Fig.3 that the psychological quantity of each adjective of sound quality is handled in such a manner that an adjective in the right carries with it a larger value (positive direction in the right) on the 7-step SD scale. Accordingly, when sound pressure in the frequency bands 63Hz -250Hz goes larger, listener appraisal tends to go towards "low frequency range distinct". A fact that each of the coefficients in 1KHz - 8KHz is in positive means that when the level in these bands goes larger, listener appraisal tends to go towards "low frequency range indistinct".

The coefficients are obtained as a result of calculating the results of listening tests, and, in a typified expression, the physical characteristic, in this case the sound pressure level, is shifted by each frequency band. The listeners evaluate on the change of psychological quantity on a specific psychological scale, and mark the evaluation sheet. The results of listening tests by a number of listeners are calculated. In practice, a combination of the changes in physical quantity at a plurality of frequency bands is presented to the test listeners for appraisal.

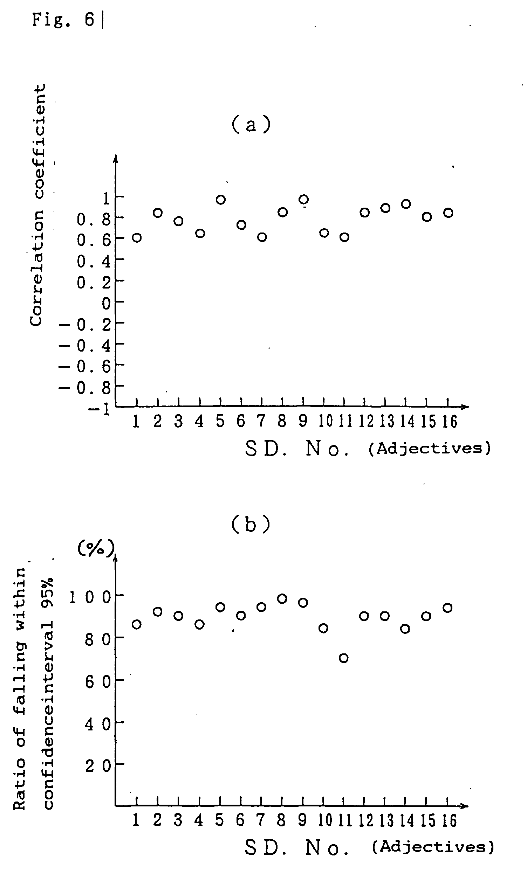

Fig.6 compares an estimated sound quality calculated using a regression formula constituted by the counter model calculation means and results of actual measurement in the experimental psychological evaluation. Fig.6(a) shows the correlation coefficient between the actual measurement value in experimental psychological evaluation and the estimated sound quality value by regression formula. Fig.6(b) shows proportion of samples the estimated sound quality value of which falls within the confidence interval 95% of actual measurement results. Horizontal axis of Fig.6 indicates the number of pairs of adjectives of sound quality. There are 50 samples for each pair of adjectives of sound quality. The results show that the correlation coefficient is higher than 0.6 in every pair of adjectives of sound quality, which means statistically meaningful with critical rate 1%. As to the proportion of samples that fall within the confidence interval 95%, although item (11) "well-balanced - ill-balanced of frequency response" (ref. Fig.3) is approx. 70%, other adjectives of sound quality have an accuracy as high as over 84%, as shown in Fig.6(b).

As described above, because of the use of sound pressure frequency characteristic, among other physical characteristics, which is most influential to the sound quality, a counter model has been constituted with a very high accuracy.

Although a frequency range is divided at one octave interval into 10 frequency bands in this exemplary case, it may be divided at a finer interval, e.g. 1/3 octave, if many samples are available with respect to the sound frequency characteristic; then the accuracy of the counter model is further increased. Or, a critical bandwidth may be used to be closer to the human auditory mechanism.

Next, description is made on an embodiment, wherein the compensation characteristics extracting means 20 is made to be further practical.

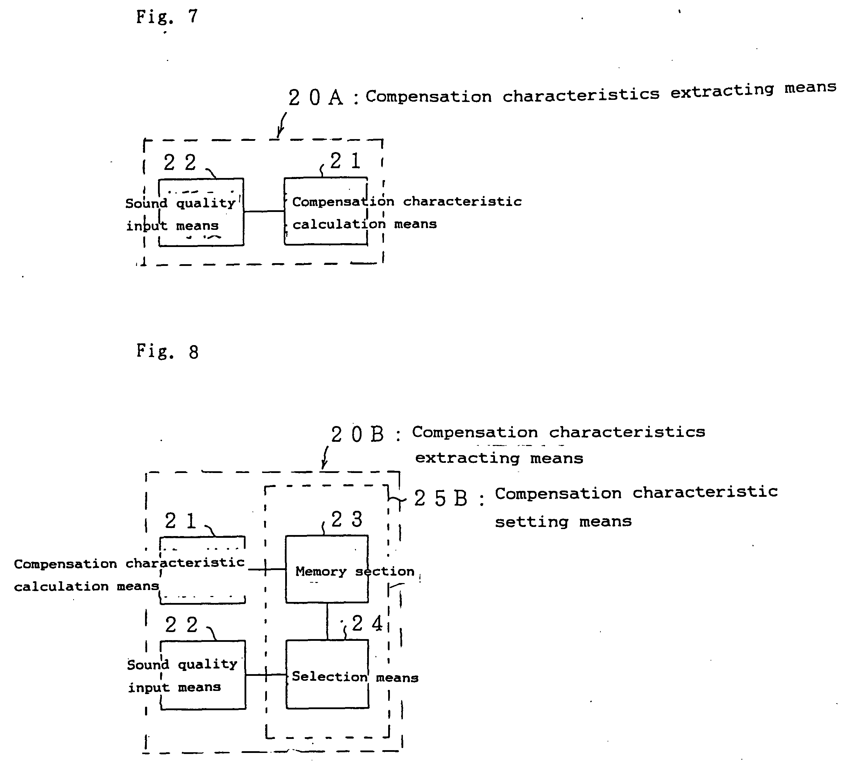

Fig.7 is a block diagram showing basic constitution of a first compensation characteristics extracting means 20A. In Fig.7, numeral 21 denotes a compensation characteristic calculation means, 22 a sound quality input means.

When sound quality input means 22 receives signal of a desired sound quality, compensation characteristic calculation means 21 calculates a compensation characteristic for realizing the sound quality by using the quantitative counter model constituted. For the calculation method, there is a method wherein the physical quantities used in the regression formula are shifted at a same rate, a method wherein the shifting is weighted with the regression coefficient of the regression formula, and a method wherein the shifting is weighted with the correlation coefficient of the physical quantities and the psychological quantities.

For example, suppose a regression formula regarding the feeling of "powerfulness" is represented by formula (2):

$$Z = 2.0X125 + 1.0X250 - 3.0X4K \qquad (2)$$

where, Z is the psychological quantity representing the feeling of "powerfulness", X125 is a deviation level [dB] at the frequency band 125Hz, X 250 is a deviation level [dB] at the frequency band 250Hz, and X4K is deviation level [dB] at the frequency band 4KHz.

Firstly, the case where the physical quantity is shifted at the same rate is contemplated. In order to shift by 6 the feeling of powerfulness Z to the positive direction, raise the 125Hz and the 250Hz bands by 1dB from the present characteristic, and damp the 4KHz band by 1dB. Thus, by controlling three frequency bands at a same level (1dB), the targeted feeling of powerfulness is realized.

Next, a case where the shifting is weighted by the regression coefficient is contemplated. Here, each of the frequency bands is controlled in the sequence from the one that bears the largest influence on the sound quality to be controlled. As formula (2) shows, ratio of regression coefficient on the frequency bands 125Hz, 250Hz and 4KHz is 2 : 1 : 3, so the physical quantities are shifted also in line with the ratio. In order to shift the feeling of powerfulness Z by 2.8 towards positive direction, raise the 125Hz band by 0.4dB, 250Hz band by 0.2dB, and damp the 4KHz band by 0.6dB from the present frequency characteristic.

The same idea applies also in a case of weighting with the correlation coefficient. For example, suppose the regression formula regarding the feeling of powerfulness is the formula (2), and the correlation coefficient between each respective frequency band and the feeling of powerfulness takes the following value (-1< correlation coefficient R< 1):

Correlation coefficient on 125Hz R125 = 0.4
Correlation coefficient on 250Hz R250 = 0.3
Correlation coefficient on 4KHz R4K = -0.5

In this case, ratio of correlation coefficient R on the 125Hz, 250Hz and 4KHz is 0.4 : 0.3 : 0.5, so the physical quantities are shifted also in line with the ratio.

For example, in order to shift the feeling of powerfulness by 5.2 towards positive direction, raise the 125Hz band by 0.8dB, the 250Hz band by 0.6dB and damp the 4KHz band by 1.0dB from the present frequency characteristic.

The calculation procedure for these values is as follows:

$$Z = 2.0x0.8 + 1.0x0.6 - 3.0x(-1.0) = 5.2$$

As described above, a compensation characteristic for realizing a desired sound quality is set with a high precision, because the compensation characteristic is calculated based on the quantitative counter model between the physical quantity and the psychological quantity.

Now in the following, a second compensation characteristics extracting means 20B is described.

Fig.8 is a block diagram showing the basic constitution of a second compensation characteristics extracting means 20B. In Fig. 8, numeral 21 denotes a compensation characteristic calculation means, 22 a sound quality input means, 23 a memory section, 24 a selection means, and 25B a compensation characteristic setting means.

Compensation characteristic calculation means 21 is, like the one in Fig.7, a means for calculating compensation characteristics to realize varieties of sound qualities. Memory section 23 is a memory for recording a compensation characteristic calculated in compensation characteristic calculation means 21 and the sound quality as a pair.

The method of calculating the compensation characteristic remains the same as the one described above.

Selection means 24 is a means for selecting, upon inputting of a desired sound quality in sound quality input means 22, a compensation characteristic out of memory section 23 to realize the sound quality. The Signal processing means 2 of Fig. 1 then controls the sound quality using a compensation characteristic selected by compensation characteristics extracting means 20B.

As described above, a compensation characteristic for realizing a desired sound quality can be set within a short period of time with a high precision, because a compensation characteristic calculated in advance based on the quantitative counter model between the physical quantity and the psychological quantity is recorded together with the corresponding sound quality as a pair in memory section 23.

Now in the following, a third compensation characteristics extracting means 20C is described.

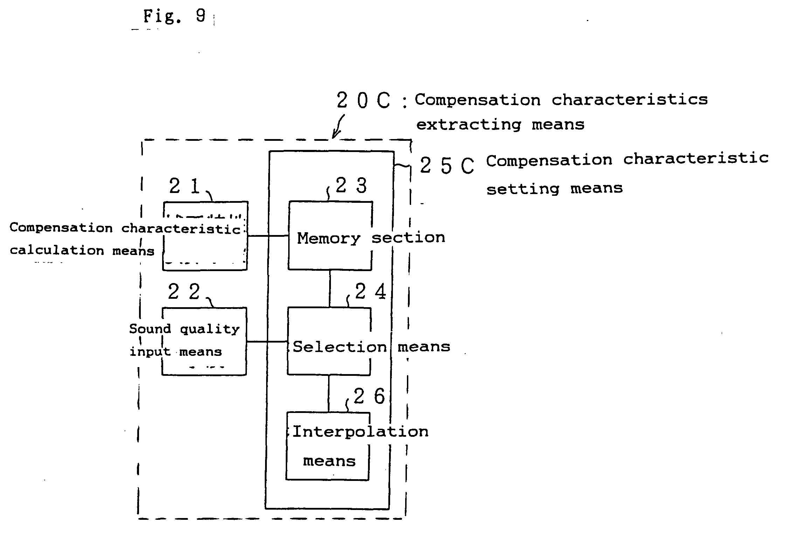

Fig.9 is a block diagram showing the basic constitution of a compensation characteristics extracting means 20C. In Fig.9, numeral 21 denotes a compensation characteristic calculation means, 22 a sound quality input means, and a compensation characteristic setting means 25 is comprised of a memory section 23, a selection means 24 and an interpolation means 26.

As in the second compensation characteristics extracting means 20B, in a third compensation characteristics extracting means 20C, compensation characteristics for realizing varieties of sound qualities are calculated in advance by compensation characteristic calculation means 21, and the sound quality and the compensation characteristic are recorded in pairs in memory section 23. Method of calculating the compensation characteristic remains the same as in the first compensation characteristics extracting means 20A.

When sound quality input means 22 receives a desired sound quality, selection means 24 selects out of memory section 23 a compensation characteristic for realizing the sound quality. However, in the case when the inputted sound qualities do not exist in the memory section, selection means 24 picks two kinds of compensation characteristics from the memory, e.g. the nearest value among the values higher than that of the sound quality and the nearest value among the values lower than that of the sound quality. The interpolation means 26 then calculates a final compensation characteristic by interpolating between the two kinds of compensation characteristics. In the calculation, a linear interpolation is a usual practice; however, any other interpolation method may of course be used. Following interpolation, the signal processing means 2 controls the sound quality using the final compensation characteristic calculated by means of interpolation. Although in this case the interpolation calculation is conducted using two kinds of compensation characteristics nearest to the inputted sound quality, the calculation may use more than two kinds of compensation characteristics.

As described above, because a compensation characteristic calculated based on the quantitative counter model between the physical quantity and the psychological quantity is recorded in advance together with corresponding sound quality in pairs, and a compensation characteristic is calculated by a simple interpolation process, a compensation characteristic for realizing the inputted sound quality can be set at a higher precision within a short period of time.

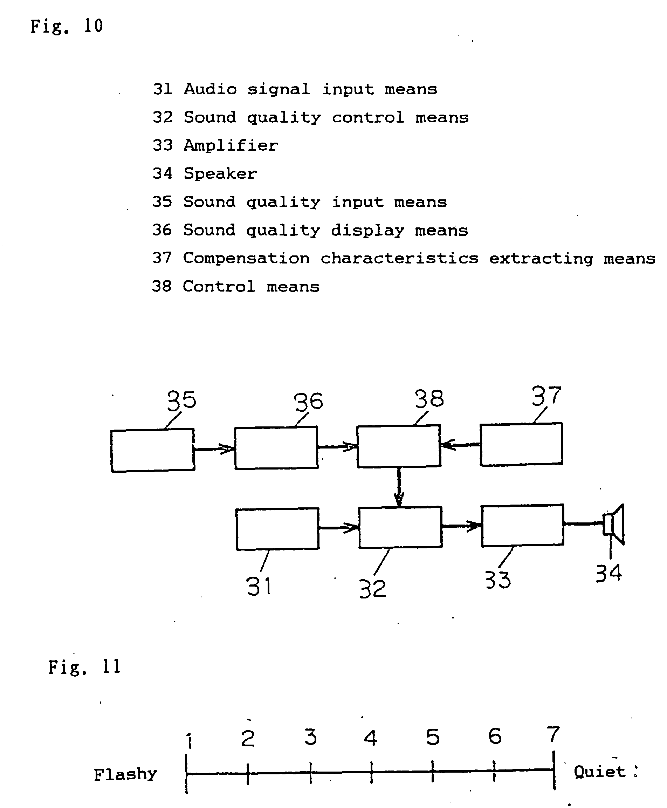

Fig.10 is a block diagram showing the basic constitution of a second embodiment of the present invention. In Fig.10, numeral 31 denotes an audio signal input means, 32 a sound quality control means, 33 an amplifier, 34 a loudspeaker, 35 a sound quality input means, 36 a sound quality display means, 37 a compensation characteristics extracting means, 38 a control means.

A listener inputs a desired sound quality to sound quality input means 35 referring to the psychological category scale displayed by sound quality display means 36. The inputted sound quality is displayed on sound quality display means 36 at the same time.

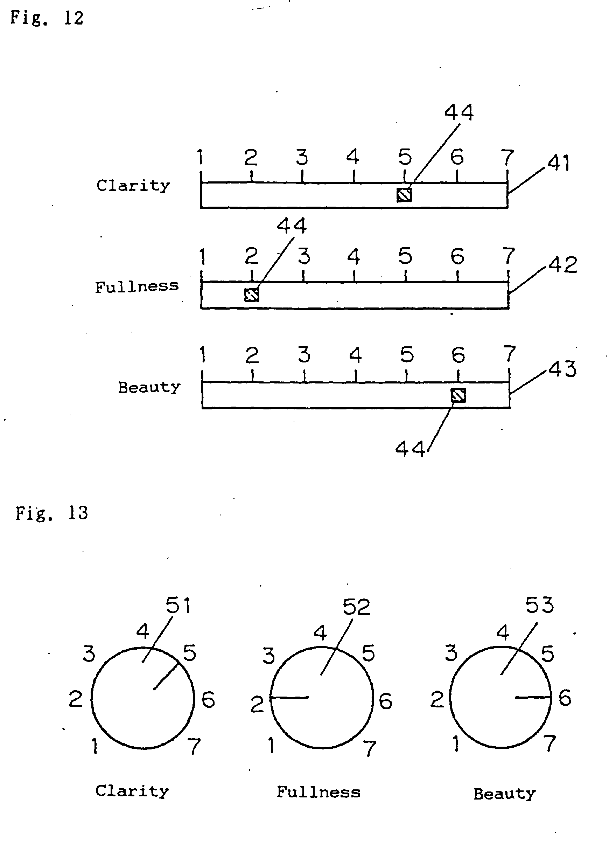

Fig. 11 shows an example of a psychological category scale. The sound quality is inputted with a scale value on the psychological category scale. In this example, the scale value is disposed at an equal interval ranging from mark 1 to mark 7 however, any marks would do in so far as they are ordinal scales.

The adjectives of sound quality used on psychological category scale are exemplified in Fig.3. The factor of sound quality obtained by applying the factor analysis may be used instead. Plural psychological category scales extracted through the factor analysis method turn out to be scales which bear little relation to each other, as explained earlier eg. "clarity", "beauty", "powerfulness".

Fig.12 shows example of a sound quality display means. In Fig.12, numerals 41, 42 and 43 denote psychological category scales, and 44 the location of an inputted sound quality. Here, the three psychological category scales are displayed independently. Scale 41 is a psychological category scale regarding the clarity, brilliance and flashiness, and is named "Clarity". Scale 42 is a psychological category scale regarding the fullness and thickness, and is named "Fullness". Scale 43 is a psychological category scale regarding the beauty and balance, and is named "Beauty". These three kinds of scales have been obtained by applying the factor analysis method to the results of sound quality appraisal experimented using the adjectives of sound quality in Fig.3; these are the psychological category scales which have little relevance to each other. Listener may designate a sound quality with joystick, mouse, etc. on each respective psychological category scale displayed. Or, as shown in Fig.13, the sound quality may be inputted by means of rheostats corresponding to each psychological category scale. In Fig.13, numeral 51 denotes a rheostat for controlling the sound quality on the psychological category scale regarding the clarity, 52 a rheostat for controlling the sound quality on the psychological category scale regarding the fullness, 53 a rheostat for controlling the sound quality on the psychological category scale regarding the beauty. In Fig. 13, the clarity is set at mark 5, the fullness at mark 2, the beauty at mark 6.

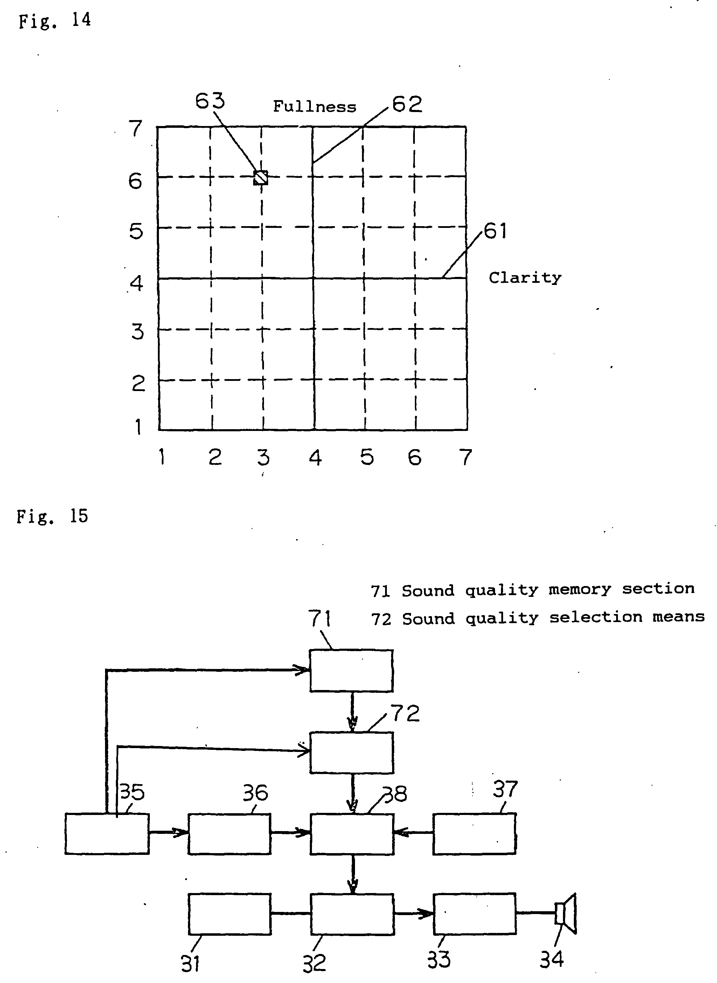

Fig.14 shows another example of a sound quality display means. In Fig.14, numerals 61 and 62 designate psychological category scales, and 63 the location of an inputted sound quality. In this case, a two-dimensional plane is constituted by the two kinds of psychological category scales, and the location of an inputted sound quality is shown on the plane. Horizontal axis 61 is supposed to be a psychological category scale of e.g. clarity, and vertical axis 62 to be a psychological category scale of e.g. fullness. When the inputting of a sound quality is performed by designating the coordinates displayed on the two-dimensional plane with a mouse, joystick, etc. In Fig.14, the clarity is set at mark 3, the fullness at mark 6.

Thus, by displaying a plane constituted by the psychological category scales, and an inputted sound quality at a same time on real-time basis, it enables a listener to input a desired sound quality with a simple operation.

In the above, a case of one-dimensional appraisal scale and display in two-dimensional plane is exemplified; however, the display may be conducted with a three-dimensional space constituted by three psychological category scales, or with a combination thereof.

As described above, a listener inputs a desired sound quality by using sound quality input means 35 referring to sound quality display means 36. The compensation characteristics extracting means 37 then extracts a compensation characteristic corresponding to the inputted sound quality. The compensation characteristic is extracted based on a regression formula, wherein the sound quality is expressed in a form of linear primary unification with the amplitude frequency characteristic. For example, suppose a regression formula regarding the fullness is represented by formula (3),

$$W = 2.0X125 - 1.0X4K - 1.0X8K \tag{3}$$

where, W is a psychological quantity regarding the fallness, X125 a deviation level in the 125Hz frequency band [dB], X4K a deviation level in the 4KHz frequency band [dB], and X8K a deviation level in the 8KHz frequency band [dB].

In order to make the fullness to be mark 4, raise the 125Hz by 1dB, lower the 4KHz by 1dB and lower the 8KHz by 1dB. Although many other methods of calculation may be thinkable, a method of controlling frequency bands used in the regression formula by a same gain is employed in the present case.

Other methods include a method, like the one described in the first embodiment, of applying weights based on the regression coefficient and the correlation coefficient between each frequency band and the sound quality(in this case, the fullness). Such are the method of mainly controlling the frequency bands that have great influence on the sound quality. As an example, a method of weighting with the regression coefficient is described below. Suppose a regression formula regarding the fullness is expressed by formula (3). When, the ratio of regression coefficient on the 125Hz, 4KHz, 8KHz is 2 : 1 : 1; and the level of each respective frequency band is shifted according to the value of the ratio. Namely, in order to make the fullness to be mark 6, raise the 125Hz by 2dB, lower the 4KHz by 1dB, and lower the 8KHz by 1dB. The same idea applies in a case where the weighting is done with the correlation coefficient.

As another example, suppose a regression formula regarding the fullness and the clarity is expressed by formula (4). This is a formula for obtaining the physical characteristic from the sound quality of fullness and clarity; while formula (3) is a one to obtain the sound quality from each physical characteristic individually.

$$X125 = aW + bZ$$

$$X250 = cW + dZ$$

$$X500 = eW + fZ$$

$$X1K = gW + hZ$$

$$X2K = iW + jZ$$

$$X4K = kW + lZ$$

$$X8K = mW + nZ$$

$$X16K = oW + pZ \tag{4}$$

where,

W represents psychological quantity of fullness,
Z represents psychological quantity of clarity.
X125 is deviation level in 125Hz frequency band [dB]
X250 is deviation level in 250Hz frequency band [dB]
X500 is deviation level in 500Hz frequency band [dB]
X1K is deviation level in 1KHz frequency band [dB]
X2K is deviation level in 2KHz frequency band [dB]
X4K is deviation level in 4KHz frequency band [dB]
X8K is deviation level in 8KHz frequency band [dB]
X16K is deviation level in 16KHz frequency band [dB]
a,b,c,d,e,f,g,h,i,j,k,l,m,n,o,p are coefficients.

The physical characteristic of each frequency band is obtainable by putting desired marks of the fullness and the clarity into formula (4). The calculation with formula (4) is simpler, as compared with formula (3). Calculation results corresponding to plural sound qualities may be put into memory in advance, and a compensation characteristic extracted is set to sound quality control means 32 by control means 38. In the mean time, a signal inputted in audio signal input means 31 is controlled in the sound quality by sound quality control means 32 in accordance with a compensation characteristic set by control means 38, and then amplified by amplifier 33 to be reproduced by loudspeaker 34.

Now in the following, a third embodiment of the present invention is described referring to the drawings. Fig. 15 is a block diagram showing the basic constitution of a third embodiment of the present invention.

In Fig.15, numeral 31 denotes an audio signal input means, 32 a sound quality control means, 33 an amplifier, 34 a loudspeaker, 35 a sound quality input means, 36 a sound quality display means, 37 a compensation characteristics extracting means, 38 a control means, 71 a sound quality memory section, 72 a sound quality selection means.

In the same way as described in the second embodiment, a listener inputs a desired sound quality in terms of sound quality scale, such as, for example, the clarity with mark 3 and the fullness with mark 6, using sound quality input means 35. And, whenever necessary, the listener records the inputted sound qualities in the sound quality memory section 71. The sound quality memory section 71 is capable of recording a plurality of sets of sound qualities. When the listener selects a recorded sound quality using the sound quality selection means 72, a compensation characteristic corresponding to the sound quality is set to the sound quality control means 32, and sound quality is thus controlled.

Now, a case where a listener varies the sound quality in accordance with the kind of music to be reproduced is contemplated. Suppose a listener's favourite is, for example, the clarity 2 marks and the fullness 4 marks for classical music; the clarity 5 marks and the fullness 5 marks for pop music; the clarity 3 marks and the fullness 4 marks for jazz. These values of sound quality scale together with their corresponding names (in this case: classical, pop, jazz) are put into sound quality memory section 71. By selecting through sound quality selection means 72 a name already memorized in sound quality memory section 71, a listener can readily have a sound quality that was once realized in the past realized once again. In this case, a sound quality is selected by name of the kind of music to be reproduced; however, the means of selection is not limited to names.

As described above, by having plural inputted sound qualities memorized for later selection, a sound quality that was once realized in the past can be reproduced again with a simple operation.

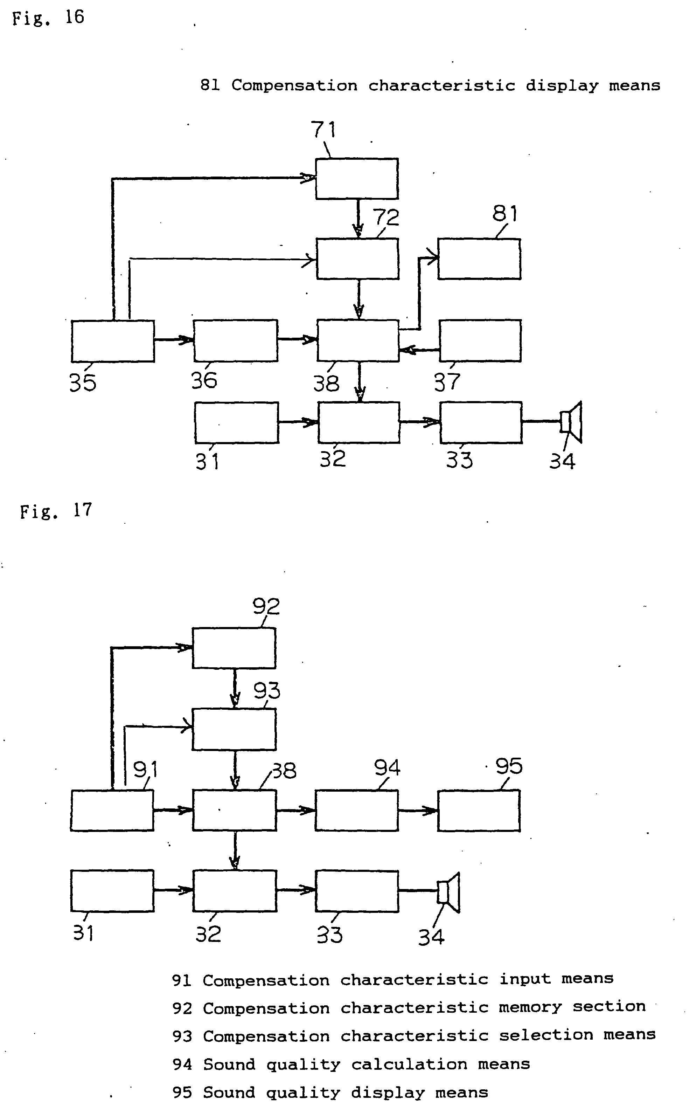

Now in the following, a fourth embodiment of the present invention is described referring to the Figures. Fig. 16 is a block diagram showing the basic constitution of a fourth embodiment of the present invention.

In Fig.16, numeral 31 denotes an audio signal input means, 32 a sound quality control means, 33 an amplifier, 34 a loudspeaker, 35 a sound quality input means, 36 a sound quality display means, 37 a compensation characteristics extracting means, 38 a control means, 71 a sound quality memory section, 72 a sound quality selection means, and 81 a compensation characteristic display means.

A listener controls the sound quality in the same manner as in the second embodiment and the third embodiment. In such as constitution, a compensation characteristic for realizing the inputted sound quality is displayed by the compensation characteristic display means 81 on a real-time basis.

As described above, because the listener can visually confirm how the compensation characteristic changes when a sound quality is inputted, the psychological effects regarding the sound quality control are enhanced.

Next, a fifth embodiment of the present invention is described referring to the Figures.

Fig.17 is a block diagram showing the basic constitution of a fifth embodiment of the present invention. In Fig. 17, numeral 31 denotes an audio signal input means, 32 a sound quality control means, 33 an amplifier, 34 a loudspeaker, 38 a control means, 91 a compensation characteristic input means, 92 a compensation characteristic memory section, 93 a compensation characteristics selection means, 94 a sound quality calculation means, and 95 a sound quality display means.

A listener inputs through the compensation characteristic input means 91 a compensation characteristic for controlling the sound quality. Herein, like the case with conventional analog graphic equalizer the gain value and the Q value of each frequency band are inputted, and/or the sound pressure frequency characteristic itself is inputted on a CRT with mouse, joystick, cursor key, etc. and, the inputted compensation characteristic is set by the control means 38 to the sound quality control means 32. Here, the sound quality calculation means 94 quantitatively calculates how the sound quality changes under the compensation characteristic; the result is displayed in the sound quality display means 95.

In the meantime, an audio signal inputted into the audio signal input means 31 is controlled in sound quality by the sound quality control means 32, and amplified by amplifier 33 to be reproduced through loudspeaker 34.

Whenever necessary, the listener records the inputted compensation characteristic in the compensation characteristic memory section 92. The compensation characteristic memory section is capable of recording a plurality of compensation characteristics. When a recorded compensation characteristic is selected by the compensation characteristic selection means 93, the compensation characteristic is set to the sound quality control means 32 and the sound quality is controlled accordingly.

In the sound quality calculation means 94, the calculation is performed by a quantitative corresponding formula between the sound quality and the physical characteristic. The corresponding formula here is a regression formula expressed as a linear primary unification of the sound quality and the physical characteristic, where the sound quality represents a scale value on the psychological category scale, and the physical characteristic represents sound amplitude-frequency characteristics divided into a plurality of frequency bands.

For example, suppose a regression formula regarding the feeling of powerfulness is expressed by formula (5), and a regression formula regarding the clarity by formula (6); for the sake of explanation, the physical characteristic in the formula employs only the difference of level from mean sound pressure level.

$$Y = 0.5X64+3.0X125+1.0X250-0.5X1K-0.5X2K-1.0X4K-1.0X8K \qquad (5)$$

where, Y is a psychological quantity representing the feeling of powerfulness.

X64 is deviation level in 64Hz frequency band [dB]
X125 is deviation level in 125Hz frequency band [dB]
X250 is deviation level in 250Hz frequency band [dB]
X1K is deviation level in 1KHz frequency band [dB]
X2K is deviation level in 2KHz frequency band [dB]
X4K is deviation level in 4KHz frequency band [dB]
X8K is deviation level in 8KHz frequency band [dB]

$$Z = -0.5X250-1.0X500+2.0X4K+1.0X8K+0.5X16K \qquad (6)$$

where,

Z is a psychological quantity representing the clarity.
X250 is deviation level in 250Hz frequency band [dB]
X500 is deviation level in 500Hz frequency band [dB]
X4K is deviation level in 4KHz frequency band [dB]
X8K is deviation level in 8KHz frequency band [dB]
X16K is deviation level in 16KHz frequency band [dB]

Suppose the value of the difference in level in each frequency band is, for example, -5dB in 64Hz band, +2dB in 125Hz band, +3dB in 250Hz band, +2dB in 500Hz band, -2dB in 1KHz band, -1dB in 2KHz band, +2dB in 4KHz band, +2dB in 8KHz band, 0dB in 16KHz band. Using these values of physical characteristic the scale values regarding the feeling of powerfulness and clarity are calculated by formula (5) and formula (6); the results turn out to be 4.0 marks for the feeling of powerfulness and 2.5 marks for clarity. The calculation results are displayed in sound quality display means 95. Here, like Fig.12 or Fig.14 for example, the calculation results are displayed on the psychological category scale.

As described above, because a listener can visually confirm how the psychological sound quality changes when the physical characteristic is varied, the psychological effects regarding the sound quality control is further enhanced. And a desired sound quality is readily realized.

In the above description, the level difference between the mean sound pressure level of the whole frequency band and the level of each respective frequency band is used as the deviation level; where the sound pressure frequency characteristic of a sound reproduction apparatus is divided into n frequency bands, the total sum of the sound pressure at each of the frequency bands divided by n is regarded as the mean sound pressure level, and the difference of each frequency band from said mean sound pressure level is regarded as the deviation level. However, other such differences such as the level difference between the level of each of the frequency bands and a certain fixed value of sound pressure level, the sound pressure level at a specific frequency (e.g. 1KHz), the largest/smallest level in each band, the mean level when the A-weighting characteristics or other compensation is applied over the whole frequency range, etc. respectively, may also be used as the deviation level.

In the descriptions, a frequency range has been divided into frequency bands at one octave interval between their centre frequencies; however it is not intended to limit to such a division.

Further, besides the sound pressure frequency characteristic, other physical characteristics such as the distortion characteristic, the phase characteristic, the transition characteristic, etc. may also be used as the physical characteristic in the present invention.

The values used in the above embodiments are of an exemplary nature, and these are not to be interpreted as limiting. The constitutions described and or shown in drawings are also of an exemplary nature.

**Claims**

1. A sound quality control system arranged to control the frequency spectrum of an audio input signal to obtain one or more user-defined subjective sound qualities upon reproduction of said signal in a sound reproduction apparatus, said sound quality control system comprising:

    modelling means (10) for mapping one or more user-defined subjective quantitative values which each correspond to the respective one or more user-defined subjective sound qualities to a plurality of characteristic physical quantities which correspond to a respective plurality of frequency bands within a predetermined frequency range of the sound reproduction apparatus, said modelling means further comprising:

        physical quantity input means (11) for inputting the characteristic physical quantities for the sound reproduction apparatus;
        psychological quantity input means (12) for inputting said one or more user-defined subjective quantitative values based on listener responses to a sound reproduced by the sound reproduction apparatus;
        correlation coefficient calculation means (13) for calculating a plurality of correlation coefficients between said characteristic physical quantities and said user-defined subjective quantitative values; and
        counter-model calculation means (14) for calculating a quantitative counter-relationship between said characteristic physical quantities and said user-defined subjective quantitative values based on the calculated correlation coefficients;

    and wherein said sound quality control system further comprises:

        compensation characteristic extracting means (20) for generating a frequency compensation characteristic based on said quantitative counter-relationship; and
        signal processing means (2) for processing the frequency spectrum of the audio input signal in accordance with said frequency compensation characteristic.

2. The sound quality control system of claim 1, where a sound pressure frequency characteristic of a sound reproduction apparatus is divided into n frequency bands, a total sum of the sound pressure at each of the frequency bands divided by n is regarded as a mean sound pressure level, and a respective difference of each n frequency band from said mean sound pressure level is regarded as a deviation level of said respective n frequency band; wherein
    said physical quantity input means inputs as said characteristic physical quantities at least one of said respective deviation levels and an absolute value of respective said deviation levels.

3. The sound quality control system of claim 1 or 2, where a scale between a pair of user-defined sound qualities is graded into several steps and each step is weighted by a respective numerical value according to the graded rank to make a qualitative appraisal scale; wherein
    said psychological quantity input means inputs as the user-defined subjective quantitative values a value on the qualitative appraisal scale.

4. The sound quality control system according to any of the preceding claims, wherein said counter model calculation means performs linear primary unification of the qualitative appraisal scales of user-defined subjective quantitative values by one of a plurality of deviation levels or the absolute values of the characteristic physical quantities, and a regression formula thus obtained is employed as the quantitative counter model.

5. The sound quality control system according to any of the preceding claims, wherein said compensation characteristics extracting means comprises a sound quality input means for inputting a desired sound quality in terms of the user-defined subjective quantitative values, and a compensation characteristic calculation means for calculating a frequency compensation characteristic to determine a sound frequency quality inputted from said sound quality input means based on the quantitative counter model.

6. The sound quality control system of claim 5, wherein said compensation characteristic calculation means shifts the physical characteristic in each column of the regression formula with a same rate.

7. The sound quality control system of claim 5, wherein said compensation characteristic calculation means shifts the physical characteristic in each column of the regression formula by weighting with the value of regression coefficient.

8. The sound quality control system of claim 5, wherein said compensation characteristic calculation means shifts the control quality in each frequency band by weighting with the value of the respective correlation coefficient for that band.

9. The sound quality control system according to any of claims 1 to 4, wherein said compensation characteristics extracting means comprises a sound quality input means for inputting a desired sound quality in terms of said user-defined subjective quantitative values, a compensation characteristic calculation means for calculating a compensation characteristic to realize a sound quality inputted from said sound quality input means based on the quantitative counter model; and
   a compensation characteristic setting means for setting a frequency compensation characteristic to determine a sound quality inputted from said sound quality input means.

10. The sound quality control system of claim 9, wherein said compensation characteristic calculation means shifts the physical characteristic in each column of the regression formula at a same rate.

11. The sound quality control system of claim 9, wherein said compensation characteristic calculation means shifts the physical characteristic in each column of the regression formula by weighting with the value of regression coefficient.

12. The sound quality control system of claim 9, wherein said compensation characteristic calculation means shifts the control quantity of each frequency band by weighting with the value of the respective correlation coefficient for that band.

13. The sound quality control system of claim 9, wherein said compensation characteristic setting means comprises a memory section for recording a plurality of frequency compensation characteristics and corresponding user-defined input sound qualities, and a selection means for selecting one characteristic from said memory section.

14. The sound quality control system of claim 9, wherein said compensation characteristic setting means comprises a memory section for recording a plurality of frequency compensation characteristics and corresponding user-defined sound qualities, a selection means for selecting at least two frequency characteristics from said memory section, and an interpolation means for interpolating the at least two selected frequency compensation characteristics and calculating a further frequency compensation characteristic by interpolation to determine the sound quality set by said sound quality input means.

15. A sound quality control system arranged to control the frequency spectrum of an audio input signal to obtain one or more user-defined subjective sound qualities upon reproduction of said audio input signal in a sound reproduction apparatus, said sound quality control system comprising:

an audio signal input means (31);

a sound quality input means (35) arranged to allow a user to input a desired quantitative sound quality value according to a sound quality scale;

a sound quality display means (36) for displaying said inputted sound quality value on a real-time basis;

a compensation characteristic extracting means (37) for generating a frequency compensation characteristic corresponding to the inputted sound quality value using a pre-calculated quantitative counter relationship between a plurality of characteristic physical quantities which correspond to a respective plurality of frequency bands within a predetermined frequency range of the sound reproduction apparatus and one or more user defined subjective quantitative values which each correspond to the respective one or more user-defined subjective sound qualities said pre-calculated quantitative counter relationship being based on correlation coefficients between said characteristic physical quantities and said user-defined subjective quantitative values; and

a sound quality control means (32) including a signal processing means for processing the frequency spectrum of the audio input signal in accordance with said frequency compensation characteristic.

16. A sound quality control system according to claim 15, wherein said sound quality scale is graded into several steps and each step is weighted by a numerical value according to the respective graded step.

17. The sound quality control system of claim 15 or 16, wherein said sound quality input means is further arranged to allow a user to input a plurality of quantitative sound quality values, each respectively relating to a different user-defined subjective sound quality.

18. The sound quality control system according to claim 15 or 16, wherein said sound quality input means is further arranged to allow a user to input a plurality of quantitative sound quality values, each respectively relating to a different user-defined subjective sound quality and each according to a respective different sound quality scale unrelated to each other.

19. The sound quality control system according to any of claims 15 to 18 wherein said sound quality display means displays at least more than one one-dimensional sound quality scale, or a two-dimensional plane and a three-dimensional space constituted by sound quality scales of more that two categories, or both of the aforementioned two, and a user-defined sound quality value inputted from said sound quality input means, on a real-time and simultaneous basis.

20. A sound quality control system according to any of claims 18 to 19 and further comprising:

a sound quality memory section for recording said inputted quantitative sound quality value; and

a sound quality selection means for selecting said quantitative sound quality value recorded.

21. A sound quality control system according to claim 20, further comprising:

a compensation characteristic display means for displaying the frequency compensation characteristic generated by said compensation characteristic extracting means.

22. A sound quality control system arranged to control the frequency spectrum of an audio input signal to adjust one or more user-defined subjective sound qualities upon reproduction of said audio input signal in a sound reproduction apparatus, said sound quality control system comprising:

a compensation characteristic input means (91) for inputting a compensation characteristic used to adjust the audio input signal;

a compensation characteristic memory section (92) for recording said inputted compensation characteristic;

a compensation characteristic selection means (93) for selecting a recorded compensation characteristic from said memory section;

sound quality control means (32) for receiving said audio input signal and controlling the frequency spectrum of said signal to adjust said signal;

control means (38) for controlling the sound quality control means based on an output of said compensation selection means;

sound quality calculation means (94) for calculating one or more quantitative sound quality values respectively indicative of the user-defined subjective sound qualities based on data of said selected compensation characteristic and using a pre-calculated quantitative counter-relationship between a plurality of characteristic physical quantities which correspond to a respective plurality of frequency bands within a predetermined frequency range of the sound reproduction apparatus and one or more user-defined subjective quantitative values which each correspond to the respective one or more user defined subjective sound qualities said pre-calculated quantitative counter relationship being based on correlation coefficients between said characteristic physical quantities and said user-defined subjective quantitative values; and

sound quality display means (95) for displaying said calculated quantitative sound quality values.

23. The sound quality control system of claim 22, wherein said compensation characteristic input means inputs a datum foe compensating the amplitude frequency spectral characteristic of the input signal.

24. The sound quality control system of claim 22 or 23, wherein said pre-calculated quantitative counter-relationship is a regression formula in which the user-defined subjective sound quality is represented in a form of linear unification of the plurality of characteristic physical quantities.

25. The sound quality control system of claim 24, where a scale relating to one of the user-defined sound qualities is graded into several steps and each step is weighted by numerical value according to the graded rank to make a sound quality scale; wherein

said regression formula treats a value on sound quality as the quantitative sound quality value.

26. The sound quality control system of claim 24 or 25, where the amplitude frequency characteristic of the compensation characteristic inputted from said compensation characteristic input means is divided into n frequency bands, and a total sum of the sound pressure at each of the frequency bands divided by n is regarded as the mean sound pressure level; wherein

said regression formula treats at least one among the difference in sound pressure at each frequency band from said mean sound pressure level and the absolute value thereof as the characteristic physical quantities.

27. The sound quality control system according to any of claims 22 to 26, wherein said sound quality display means displays at least more than one one-dimensional appraisal scale, or a two-dimensional plane and a three-dimensional space constituted by the sound quality scales of more than two categories, or both of the aforementioned two, and a sound quality inputted from said sound quality input means, on real-time and simultaneous basis.

28. A sound quality modelling method for quantitatively modelling a relationship between one or more user-defined subjective sound qualities and a plurality of characteristic physical quantities relating to the sound produced by reproducing an audio input signal in a sound reproduction apparatus, said method comprising the steps of:-

reproducing the audio input signal in the sound reproduction apparatus;

varying the plurality of characteristic physical quantities relating to the produced sound wherein said quantities correspond to a respective plurality of frequency bands within a predetermined frequency range of the second reproduction apparatus;

evaluating listener responses to the produced sound using a quantitative sound quality scale to obtain one or more user-defined subjective quantitative values each relating to a respective user-defined subjective sound quality;

correlating said user-defined subjective quantitative values with said plurality of characteristic physical quantities for each band to obtain a plurality of correlation coefficients; and

calculating a quantitative counter-relationship between said characteristic physical quantities and said user-defined subjective quantitative values based on the calculated plurality of correlation coefficients.

29. A sound quality modelling method according to claim 28 wherein said quantitative counter-relationship is a regression formula obtained by linear primary unification of the plurality of characteristic physical quantities with the used-defined subjective quantitative values of the general form:

$$Z = a0 + a_1 X_1 + a_2 X_2 + \cdots + a_i X_i$$

wherein Z is a quantitative value relating to the subjective sound quality, $a_o$ to $a_i$ are coefficients, and $X_1$ to $X_i$ are the characteristic physical quantities respectively for each frequency band.

**EP 0 740 410 B1**

**Patentansprüche**

1. Tonqualität-Steuerungssystem, das ausgebildet ist, das Frequenzspektrum eines Audioeingabesignals zu steuern, um eine oder mehrere benutzerdefinierte, subjektive Tonqualitäten bei Wiedergabe des Signals in einer Tonwiedergabevorrichtung zu erhalten, wobei das Tonqualität-Steueungsystem umfasst:

   eine Modellbildungseinrichtung (10) zum Abbilden von einem oder mehreren benutzerdefinierten, subjektiven, quantitativen Werten, von denen jeder jeweils der oder den mehreren benutzerdefinierten, subjektiven Tonqualitäte(n) entspricht, auf eine Mehrzahl von charakteristischen, physikalischen Größen, die einer entsprechenden Mehrzahl von Frequenzbändern innerhalb eines vorbestimmten Frequenzbereiches der Tonwiedergabevorrichtung entsprechen, wobei die Modellbildungseinrichtung des Weiteren umfasst:

   eine Eingabeeinrichtung (11) für physikalische Größen zur Eingabe der charakteristischen, physikalischen Größen für die Tonwiedergabevorrichtung,

   eine Eingabeeinrichtung (12) für psychologische Größen zur Eingabe des einen oder der mehreren benutzerdefinierten, subjektiven, quantitativen Werte auf der Grundlage einer Zuhörerreaktion auf einen Ton, der von der Tonwiedergabevorrichtung wiedergegeben wird,

   eine Korrelationskoeffizienten-Berechnungseinrichtung (13) zur Berechnung einer Mehrzahl von Korrelationskoeffizienten zwischen den charakteristischen, physikalischen Größen und den benutzerdefinierten, subjektiven, quantitativen Werte und

   eine Zählermodell-Berechnungseinrichtung (14) zur Berechnung einer quantitativen Zählerbeziehung zwischen den charakteristischen, physikalischen Größen und den benutzerdefinierten, quantitativen Werten auf der Grundlage der berechneten Korrelationskoeffizienten,

   und wobei das Tonqualität-Steuerungssystem des Weiteren umfasst:

   eine Ausgleichskenngröße-Gewinnungseinrichtung (20) zur Erzeugung einer Frequenzausgleichskenngröße auf der Grundlage der quantitativen Zählerbeziehung, und

   eine Signalverarbeitungseinrichtung (2) zur Verarbeitung des Frequenzspektrums des Audioeingabesignals entsprechend der Frequenzausgleichskenngröße.

2. Tonqualität-Steuerungssystem nach Anspruch 1, in dem eine Schalldruck-Frequenzkennlinie einer Tonwiedergabevorrichtung in n Frequenzbänder unterteilt ist, wobei eine Gesamtsumme des Schalldrucks in jedem der Frequenzbänder dividiert durch n als ein mittlerer Schalldruckwert betrachtet wird und eine entsprechende Differenz zwischen dem jeweiligen n Frequenzband und dem mittleren Schalldruckwert als eine Abweichungsgröße des jeweiligen n Frequenzbands betrachtet wird, wobei
   die Eingabeeinrichtung für eine physikalische Größe als die charakteristischen physikalischen Größen zumindest eine der jeweiligen Abweichungsgrößen und einen Absolutwert der jeweiligen Abweichungsgrößen eingibt.

3. Tonqualität-Steuerungssystem nach Anspruch 1 oder 2, in dem eine Skala zwischen einem Paar von benutzerdefinierten Tongrößen in mehrere Schritte unterteilt ist und jeder Schritt mit einem entsprechenden numerischen Wert entsprechend dem Unterteilungsrang gewichtet ist, um eine qualitative Bewertungsskala herzustellen, wobei die Eingabeeinrichtung für psychologische Größen als die benutzerdefinierten, subjektiven, quantitativen Werte einen Wert auf der qualitativen Bewertungsskala eingibt.

4. Tonqualität-Steuerungssystem nach einem der vorhergehenden Ansprüche, in dem die Zählermodell-Berechnungseinrichtung eine lineare Hauptvereinigung der qualitativen Bewertungsskalen von benutzerdefinierten, subjektiven, quantitativen Werten durch eine Mehrzahl von Abweichungsgrößen oder die Absolutwerte der charakteristischen, physikalischen Größen durchführt, und eine derart erhaltene Regressionsformel als das quantitative Zählermodell verwendet wird.

5. Tonqualität-Steuerungssystem nach einem der vorhergehenden Ansprüche, in dem die Ausgleichskenngröße-Gewinnungseinrichtung eine Tonqualität-Eingabeeinrichtung zur Eingabe einer erwünschten Tonqualität in Größen der benutzerdefinierten, subjektiven, quantitativen Werte und eine Ausgleichskenngröße-Berechnungseinrichtung zur Berechnung einer Frequenzausgleichskenngröße umfasst, um eine Tonfrequenzqualität, die von der Tonqualität-Eingabeeinrichtung eingegeben wird, auf der Grundlage des quantitativen Zählermodells zu bestimmen.

6. Tonqualität-Steuerungssystem nach Anspruch 5, in dem die Ausgleichskenngröße-Berechnungseinrichtung die physikalische Größe in jeder Spalte der Regressionsformel in einem gleichen Maß verschiebt.

7. Tonqualität-Steuerungssystem nach Anspruch 5, in dem die Ausgleichskenngröße-Berechnungseinrichtung die physikalische Größe in jeder Spalte der Regressionsformel verschiebt, indem der Wert des Regressionskoeffizienten gewichtet wird.

8. Tonqualität-Steuerungssystem nach Anspruch 5, in dem die Ausgleichskenngröße-Berechnungseinrichtung die Steuergröße in jedem Frequenzband verschiebt, indem mit dem Wert des entsprechenden Korrelationskoeffizienten für dieses Band gewichtet wird.

9. Tonqualität-Steuerungssystem nach einem der Ansprüche 1 bis 4, in dem die Ausgleichskenngröße-Gewichtungseinrichung eine Tonqualität-Eingabeeinrichtung zur Eingabe einer erwünschten Tonqualität in Größen der benutzerdefinierten, subjektiven, quantitativen Werte, eine Ausgleichskenngröße-Berechnungseinrichtung zur Berechnung einer Ausgleichskenngröße, um eine Tonqualität, die von der Tonqualität-Eingabeeinrichtung eingegeben wird, auf der Grundlage des quantitativen Zählermodells herzustellen, und eine Ausgleichskenngröße-Einstelleinrichtung zum Einstellen einer Frequenzausgleichskenngröße umfasst, um eine Tonqualität zu bestimmen, die von der Tonqualität-Eingabeeinrichtung eingegeben ist.

10. Tonqualität-Steuerungssystem nach Anspruch 9, in dem die Ausgleichskenngröße-Berechnungseinrichtung die physikalische Größe in jeder Spalte der Regressionsformel in einem gleichen Maß verschiebt.

11. Tonqualität-Steuerungssystem nach Anspruch 9, in dem die Ausgleichskenngröße-Berechnungseinrichtung die physikalische Größe in jeder Spalte der Regressionsformel verschiebt, indem der Wert des Regressionskoeffizienten gewichtet wird.

12. Tonqualität-Steuerungssystem nach Anspruch 5, in dem die Ausgleichskenngröße-Berechnungseinrichtung die Steuergröße in jedem Frequenzband verschiebt, indem mit dem Wert des entsprechenden Korrelationskoeffizienten für dieses Band gewichtet wird.

13. Tonqualität-Steuerungssystem nach Anspruch 9, in dem die Ausgleichskenngröße-Einstelleinrichtung einen Speicherabschnitt zur Aufzeichnung einer Mehrzahl von Frequenzausgleichskenngrößen und von entsprechenden benutzerdefinierten Eingabetonqualitäten und eine Auswähleinrichtung zum Auswählen eines Merkmals aus dem Speicherabschnitt umfasst.

14. Tonqualität-Steuerungssystem nach Anspruch 9, in dem die Ausgleichskenngröße-Einstelleinrichtung einen Speicherabschnitt zur Aufzeichnung einer Mehrzahl von Frequenzausgleichskenngrößen und von entsprechenden benutzerdefinierten Tonwerten, eine Auswähleinrichtung zum Auswählen von mindestens zwei Frequenzkenngrößen aus dem Speicherabschnitt, und eine Interpolationseinrichtung zur Interpolation der zumindest zwei ausgewählten Frequenzausgleichskenngrößen und zum Berechnen einer weiteren Frequenzausgleichskenngröße durch Interpolation umfasst, um die durch die Tonqualität-Eingabeeinrichtung eingestellte Tonqualität zu bestimmen.

15. Tonqualität-Steuerungssystem, das ausgebildet ist, das Frequenzspektrum eines Audioeingabesignals zu steuern, um eine oder mehrere benutzerdefinierte, subjektive Tonqualitäten bei Wiedergabe des Audioeingabesignals in einer Tonwiedergabevorrichtung zu erhalten, wobei das Tonqualität-Steuerungssystem umfasst:

eine Audiosignal-Eingabeeinrichtung (31)

eine Tonqualität-Eingabeeinrichtung (35), die ausgebildet ist, damit ein Benutzer einen erwünschten, quantitativen Tonqualitätswert entsprechend einer Tonqualitätsskale eingeben kann,

eine Tonqualität-Anzeigeeinrichtung (36) zur Anzeige des eingegebenen Tonqualitätswerts auf einer Realzeitgrundlage,

eine Ausgleichskenngröße-Gewinnungseinrichtung (37) zur Erzeugung einer Frequenzausgleichskenngröße, die dem eingegebenen Tonqualitätswert entspricht, unter Verwendung einer im Voraus berechnete, quantitative Zählerbeziehung zwischen einer Mehrzahl von charakteristischen, physikalischen Größen, die einer entsprechenden Mehrzahl von Frequenzbändern innerhalb eines vorbestimmten Frequenzbereiches der Tonwiedergabevorrichtung entsprechen, und einem oder mehreren benutzerdefinierten, subjektiven, quantitativen Werten, die jeweils der/n jeweiligen einen oder mehreren benutzerdefinierten, subjektiven Tonqualitäten entspricht/ entsprechen, wobei der im Voraus berechneten, quantitativen Zählerbeziehung Korrelationskoeffizienten zwischen den charakteristischen, physikalischen Größen und den benutzerdefinierten, subjektiven, quantitativen Werten zugrunde liegen, und

eine Tonqualität-Steuerungseinrichtung (32), die eine Signalverarbeitungseinrichtung zum Verarbeiten des Frequenzspektrums des Audioeingabesignals entsprechend der Frequenzausgleichskenngröße enthält.

16. Tonqualität-Steuerungssystem nach Anspruch 15, in dem die Tonqualitätsskala in mehrere Schritte unterteilt ist und jeder Schritt mit einem numerischen Wert entsprechend dem jeweiligen unterteilten Schritt gewichtet ist.

17. Tonqualität-Steuerungssystem nach Anspruch 15 oder 16, in dem die Tonqualität-Eingabeeinrichtung des Weiteren ausgebildet ist, einem Benutzer zu erlauben, eine Mehrzahl von quantitativen Tonqualitätswerten einzugeben, von denen sich jeder jeweils auf eine unterschiedliche, benutzerdefinierte, subjektive Tonqualität bezieht.

18. Tonqualität-Steuerungssystem nach Anspruch 15 oder 16, in dem die Tonqualität-Eingabeeinrichtung des Weiteren ausgebildet ist, einem Benutzer zu ermöglichen, eine Mehrzahl von quantitativen Tonqualitätswerten, von denen sich jeder jeweils auf eine unterschiedliche, benutzerdefinierte, subjektive Tonqualität bezieht, jeweils entsprechend einer jeweiligen unterschiedlichen Tonqualitätsskala einzugeben, die miteinander nicht in Beziehung stehen.

19. Tonqualität-Steuerungssystem nach einem der Ansprüche 15 bis 18, in dem die Tonqualität-Anzeigeeinrichtung zumindest mehr als eine eindimensionale Tonqualitätsskala oder eine zweidimensionale Ebene und einen dreidimensionalen Raum anzeigt, der von Tonqualitätsskalen von mehr als zwei Klassen oder sowohl von den vorgenannten zwei als auch von einem benutzerdefinierten Tonqualitätswert gebildet ist, der von der Tonqualität-Eingabeeinrichtung auf Realzeit- und Gleichzeitigkeits-Grundlage eingegeben wird.

20. Tonqualität-Steuerungssystem nach einem der Ansprüche 18 bis 19, das des Weiteren umfasst:

einen Tonqualität-Speicherabschnitt zur Aufzeichnung des eingegebenen, quantitativen Tonqualitätswerts, und

eine Tonqualität-Auswähleinrichtung zum Auswählen des aufgezeichneten, quantitativen Tonqualitätswerts.

21. Tonqualität-Steuerungssystem nach Anspruch 20, das des Weiteren umfasst:
eine Ausgleichskenngröße-Anzeigeeinrichtung zur Anzeige der Frequenzausgleichskenngröße, die von der Ausgleichskenngröße-Gewinnungseinrichtung erzeugt ist.

22. Tonqualität-Steuerungssystem, das ausgebildet ist, das Frequenzspektrum eines Audioeingabesignals zu steuern, um eine oder mehrere benutzerdefinierte, subjektive Tonqualitäten bei Wiedergabe des Audioeingabesignals in einer Tonwiedergabevorrichtung einzustellen, wobei das Tonqualität-Steuerungssystem umfasst:

eine Ausgleichskenngröße-Eingabeeinrichtung (91) zur Eingabe einer Ausgleichskenngröße, das verwendet wird, das Audioeingabesignal einzustellen,

ein Ausgleichskenngröße-Speicherabschnitt (92) zur Aufzeichnung der eingegebenen Ausgleichskenngröße,

eine Ausgleichskenngröße-Auswähleinrichtung (93) zur Auswahl einer aufgezeichneten Ausgleichskenngröße aus dem Speicherabschnitt,

eine Tonqualität-Steuereinrichtung (32), die das Audioeingabesignal erhält und das Frequenzspektrum des Signals steuert, um das Signal einzustellen,

eine Steuereinrichtung (38) zur Steuerung der Tonqualität-Steuereinrichtung auf der Grundlage einer Ausgabe von der Ausgleichsauswähleinrichtung,

eine Tonqualität-Berechnungseinrichtung (94) zur Berechnung von einem oder mehreren quantitativen Tonqualitätswerten, die jeweils die benutzerdefinierten, subjektiven Tonqualitäten angeben, auf der Grundlage von Daten der ausgewählten Ausgleichskenngröße sowie unter Verwendung einer im Voraus berechneten, quantitativen Zählerbeziehung zwischen einer Mehrzahl von charakteristischen, physikalischen Größen, die einer entsprechenden Mehrzahl von Frequenzbändern innerhalb eines vorbestimmten Frequenzbereiches der Tonwiedergabevorrichtung entsprechen und einem oder mehreren benutzerdefinierten, subjektiven, quantitativen Werten, die jeweils der/n jeweiligen einen oder mehreren benutzerdefinierten, subjektiven Tonqualitäten entspricht/ entsprechen, wobei der im Voraus berechneten, quantitativen Zählerbeziehung Korrelationskoeffizienten zwischen den charakteristischen, physikalischen Größen und den benutzerdefinierten, subjektiven, quantitativen Werten zugrunde liegen, und

eine Tonqualität-Steuerungseinrichtung (32), die eine Signalverarbeitungseinrichtung zum Verarbeiten des Frequenzspektrums des Audioeingabesignals entsprechend dem Frequenzausgleichskennwert enthält.

und eine Tonqualität-Anzeigeeinrichtung (95) zur Anzeige der berechneten, quantitativen Tonqualitätswerte.

23. Tonqualität-Steuerungssystem nach Anspruch 22, in dem die Ausgleichskenngröße-Eingabeeinrichtung eine Date zum Ausgleich der Amplitudenfrequenzspektralkennwerts des Eingangssignals eingibt.

24. Tonqualität-Steuerungssystem nach Anspruch 22 oder 23, in dem die im Voraus berechnete, quantitative Zählerbeziehung eine Regressionsformel ist, in der die benutzerdefinierte, subjektive Tonqualität in einer Form einer linearen Vereinigung der Mehrzahl von charakteristischen, physikalischen Größen dargestellt ist.

25. Tonqualität-Steuerungssystem nach Anspruch 24, in dem eine Skala, die sich auf eine der benutzerdefinierten Tonqualitäten bezieht, in mehrere Schritte unterteilt ist und jeder Schritt mit einen numerischen Wert entsprechend dem Unterteilungsrang gewichtet ist, um eine Tonqualitätsskala herzustellen, wobei die Regressionsformel einen Wert über die Tonqualität als den quantitativen Tonqualitätswert behandelt.

26. Tonqualität-Steuerungssystem nach Anspruch 24 oder 25, in dem der Amplituden-Frequenz-Kennwert des Ausgleichskennwerts, der von der Ausgleichskenngröße-Eingabeeinrichtung eingegeben wird, in n Frequenzbänder unterteilt ist, und eine Gesamtsumme des Schalldrucks in jedem der Frequenzbänder dividiert durch n als der mittlere Schalldruckwert betrachtet wird, wobei
die Regressionsformel zumindest eine der Differenzen zwischen dem Schalldruck in jedem Frequenzband und dem mittleren Schalldruckwert oder dessen Absolutwert als charakteristische, physikalische Größen behandelt.

27. Tonqualität-Steuerungssystem nach einem der Ansprüche 22 bis 26, in dem die Tonqualität-Anzeigeeinrichtung zumindest mehr als eine eindimensionale Bewertungsskala oder eine zweidimensionale Ebene und einen dreidimensionalen Raum anzeigt, der von Tonqualitätsskalen von mehr als zwei Klassen oder sowohl von den vorgenannten zwei als auch einem benutzerdefinierten Tonqualitätswert gebildet ist, der von der Tonqualität-Eingabeeinrichtung auf Realzeit- und Gleichzeitigkeits-Grundlage eingegeben wird.

28. Tonqualität-Modellierungsverfahren zum quantitativen Modellieren einer Beziehung zwischen einem oder mehreren benutzerdefinierte, subjektive Tonqualitäten und einer Mehrzahl von charakteristischen, physikalischen Größen, die sich auf den Ton beziehen, der durch Wiedergeben eines Audioeingabesignals in einer Tonwiedergabevorrichtung erzeugt wird, wobei das Verfahren die Schritte umfasst:

Wiedergeben des Audioeingabesignals mit der Tonwiedergabevorrichtung,

Verändern der Mehrzahl von charakteristischen, physikalischen Größen, die sich auf den wiedergegebenen Ton beziehen, wobei die Größen einer entsprechenden Mehrzahl von Frequenzbändern innerhalb eines vorbestimmten Frequenzbereiches der zweiten Wiedergabevorrichtung entsprechen,

Auswerten von Zuhörerreaktionen auf den wiedergegebenen Ton unter Verwendung einer quantitativen Tonqualitätsskala um einen oder mehrere benutzerdefinierte, subjektive, quantitative Werte zu erhalten, von denen sich jeder auf eine entsprechende, benutzerdefiniert, subjektive Tonqualität bezieht,

Korrelieren der benutzerdefinierten, subjektiven, quantitativen Werte mit der Mehrzahl von charakteristischen, physikalischen Größen für jedes Band, um eine Mehrzahl von Korrelationskoeffizienten zu erhalten, und

Berechnen einer quantitativen Zählerbeziehung zwischen den charakteristischen, physikalischen Größen und den benutzerdefinierten, subjektiven, quantitativen Werten auf der Grundlage der berechneten Mehrzahl von Korrelationskoeffizienten.

29. Tonqualität-Steuerungssystem nach Anspruch 28, in dem die quantitative Zählerbeziehung eine Regressionsformel ist, die durch lineare Hauptvereinigung der Mehrzahl von charakteristischen, physikalischen Größen mit den benutzerdefinierten, subjektiven, quantitativen Werten der allgemeinen Form erhalten wird:

$$Z = a_0 + a_1X_1 + a_2X_2 + \cdots + a_iX_i$$

worin Z ein quantitativer Wert ist, der sich auf die subjektive Tonqualität bezieht, $a_0$ bis a; Koeffizienten sind und $X_1$ bis $X_i$ die charakteristischen, physikalischen Größen für das jeweilige Frequenzband sind.

**Revendications**

1. Système de commande de la qualité du son agencé pour commander le spectre de fréquences d'un signal audio d'entrée pour obtenir une ou plusieurs qualités acoustiques subjectives définies par l'utilisation, lors de la reproduction dudit signal dans un dispositif de reproduction acoustique, ledit système de réglage de la qualité du son comprenant:

des moyens de modélisation (10) pour mettre en correspondance une ou plusieurs valeurs quantitatives subjectives définies par l'utilisateur, qui correspondent chacune à une ou plusieurs qualités subjectives respectives du son définies par un utilisateur, sur une pluralité de grandeurs physiques caractéristiques qui correspondent à une pluralité respective de bandes de fréquences dans une bande de fréquences prédéterminée du dispositif de reproduction du son, lesdits moyens de modélisation comprenant en outre:

des moyens (11) d'entrée de grandeurs physiques pour introduire les grandeurs physiques caractéristiques pour le dispositif de reproduction du son;
des moyens (12) d'entrée de quantités psychologiques pour introduire lesdites une ou plusieurs valeurs quantitatives subjectives définies par l'utilisateur sur la base de réponses d'auditeurs à un son reproduit par le dispositif de reproduction du son;
des moyens (13) de calcul de coefficients de corrélation pour calculer une pluralité de coefficients de corrélation entre lesdites grandeurs physiques caractéristiques et lesdites valeurs quantitatives subjectives définies par l'utilisateur; et
des moyens (14) de calcul d'un contre-modèle pour calculer une relation quantitative antagoniste entre lesdites grandeurs physiques caractéristiques et lesdites valeurs quantitatives subjectives définies par l'utilisateur, sur la base des coefficients de corrélation calculés; et

dans lequel ledit système de réglage de la qualité du son comprend en outre:

des moyens (20) d'extraction d'une caractéristique de compensation pour produire une caractéristique de compensation de fréquence basée sur ladite relation quantitative antagoniste; et
des moyens (2) de traitement de signaux pour traiter le spectre de fréquences du signal audio d'entrée en fonction de ladite caractéristique de compensation de fréquences.

2. Système de commande de la qualité du son selon la revendication 1, dans lequel une caractéristique de fréquence pression-fréquence du son d'un appareil de reproduction du son est divisée en n bandes de fréquences, une somme totale de la pression acoustique dans chacune des bandes de fréquences divisée par n est considérée comme le niveau de pression acoustique moyen, et une différence respective de chacune des n bandes de fréquences par rapport audit niveau de pression acoustique moyen est considérée comme un niveau d'écart desdites n bandes de fréquences respectives;
lesdits moyens d'entrée de grandeurs physiques introduisant en tant que grandeurs physiques caractéristiques au moins l'un desdits niveaux d'écart respectifs et une valeur absolue desdits niveaux d'écart respectifs.

3. Système de commande de la qualité du son selon la revendication 1 ou 2, dans lequel une échelle entre un couple de qualités de son définies par l'utilisateur est graduée en plusieurs échelons et chaque échelon est pondérée par une valeur numérique respective en fonction du rang gradué pour obtenir une échelle d'évaluation quantitative; lesdits moyens d'entrée de grandeurs psychologiques introduisant en tant que valeurs quantitatives subjectives définies par l'utilisateur une valeur de l'échelle d'évaluation qualitative.

4. Système de commande de la qualité du son selon l'une quelconque des revendications précédentes, selon. lequel lesdits moyens de calcul du contre-modèle réalisent une unification primaire linéaire des échelles d'évaluation qualitative des valeurs qualitatives subjectives définies par l'utilisateur ou par l'une d'une pluralité de niveaux de décision ou de valeurs absolues des grandeurs physiques caractéristiques, et une formule de régression ainsi obtenue est utilisée en tant que contre-modèle quantitatif.

5. Système de commande de réglage de la qualité du son selon l'une quelconque des revendications précédentes, dans lequel lesdits moyens d'extraction de caractéristiques de compensation comprennent des moyens d'entrée de la qualité du son pour introduire une qualité de son désirée en termes de valeurs quantitatives subjectives définies par l'utilisateur, et des moyens de calcul de caractéristiques de compensation pour calculer une caractéristique de compensation afin de déterminer une qualité de fréquence acoustique introduite à partir desdits moyens d'entrée de la qualité du son sur la base du contre-modèle quantitatif.

6. Système de commande de la qualité du son selon la revendication 5, dans lequel lesdits moyens de calcul de caractéristiques de compensation décalent la caractéristique physique dans chaque colonne de la formule de régression à la même cadence.

7. Système de commande de la qualité du son selon la revendication 5, dans lequel lesdits moyens de calcul de caractéristiques de compensation décalent la caractéristique physique dans chaque colonne de la formule de régression par pondération avec la valeur du coefficient de régression.

8. Système de contrôle de la qualité du son selon la revendication 5, dans lequel lesdits moyens de calcul de caractéristiques de compensation décalent la qualité du son dans chaque bande de fréquences par pondération avec la valeur du coefficient de corrélation respective pour cette bande.

9. Système de contrôle de la qualité du son selon l'une quelconque des revendications 1 à 4, dans lequel lesdits moyens d'extraction de caractéristiques de compensation comprennent des moyens d'entrée de la qualité du son servant à introduire une qualité de son désirée en terme de valeurs quantitatives subjectives définies par l'utilisateur, des moyens de calcul de caractéristiques de compensation pour calculer une caractéristique de compensation afin d'obtenir une qualité du son introduite à partir desdits moyens d'entrée de qualité du son, basée sur le contre-modèle quantitatif; et des moyens de réglage de caractéristiques de compensation pour régler une caractéristique de compensation de fréquence pour déterminer une qualité de son introduite à partir desdits moyens d'entrée de la qualité du son.

10. Système de commande de la qualité du son selon la revendication 9, dans lequel lesdits moyens de calcul de caractéristiques de compensation décalent la caractéristique physique dans chaque colonne de la formule de régression à la même cadence.

11. Système de commande de la qualité du son selon la revendication 9, dans lequel lesdits moyens de calcul de caractéristiques de compensation décalent la caractéristique physique dans chaque colonne de la formule de régression par pondération avec la valeur du coefficient de régression.

12. Système de commande de la qualité du son selon la revendication 9, dans lequel lesdits moyens de calcul de caractéristiques de compensation décalent la quantité de réglage de chaque bande de fréquences par pondération avec la valeur du coefficient de corrélation respectif pour cette bande.

13. Système de commande de la qualité du son selon la revendication 9, dans lequel lesdits moyens de réglage de caractéristiques de compensation comprennent une section de mémoire pour enregistrer une pluralité de caractéristiques de compensation de fréquences et des qualités de son d'entrée correspondantes définies par l'utilisateur, et des moyens de sélection pour sélectionner une caractéristique dans ladite section de mémoire.

14. Système de commande de la qualité du son selon la revendication 9, dans lequel lesdits moyens de réglage de caractéristiques de compensation comprennent une section de mémoire pour enregistrer une pluralité de caractéristiques de compensation de fréquences et des qualités de son correspondantes définies par l'utilisateur, des moyens de sélection pour sélectionner au moins deux caractéristiques de fréquence à partir de ladite section de mémoire, et des moyens d'interpolation pour interpoler les au moins deux caractéristiques de compensation de fréquences sélectionnées et calculer une autre caractéristique de compensation de fréquence, par interpolation afin de déterminer la qualité de son réglée par lesdits moyens d'entrée de la qualité de son.

15. Système de commande de la qualité du son agencé pour régler le spectre de fréquences d'un signal audio d'entrée pour obtenir une ou plusieurs qualités de son subjectives définies par l'utilisateur, lors de la reproduction du signal audio d'entrée dans un dispositif de reproduction du son, ledit système de réglage de la qualité du son comprenant:

des moyens (31) d'entrée d'un signal audio;
des moyens (35) d'entrée de qualité de son agencés de manière à permettre à un utilisateur d'introduire une valeur de qualité de son quantitative désirée en fonction d'une échelle des qualités de son;
des moyens (36) d'affichage d'une qualité de son pour repousser ladite valeur de qualité de son introduite sur une base en temps réel;
des moyens (37) d'extraction de caractéristiques de compensation pour produire une caractéristique de compensation de fréquence correspondant à la valeur de qualité de son introduite en utilisant une relation antagoniste quantitative recalculée entre une pluralité de grandeurs physiques caractéristiques, qui correspondent à une qualité respective de bandes de fréquences dans une bande prédéterminée de fréquences du dispositif de reproduction du son et une ou plusieurs valeurs quantitatives subjectives définies par l'utilisateur, qui correspondent chacune à une ou plusieurs qualités de son subjectives respectives définies par l'utilisateur, ladite relation antagoniste quantitative précalculée étant basée sur des coefficients de corrélation entre desdites grandeurs physiques caractéristiques et lesdites valeurs quantitatives subjectives définies par l'utilisateur, et
des moyens (32) de réglage de la qualité du son incluant des moyens de traitement du signal pour traiter le spectre de fréquences du signal audio d'entrée conformément à ladite caractéristique de compensation de fréquence.

16. Système de commande de la qualité du son selon la revendication 15, dans lequel ladite échelle de qualités du son est graduée en plusieurs échelons et chaque échelon est pondéré par une valeur numérique en fonction de l'échelon gradué respectif.

17. Système de commande de la qualité du son selon la revendication 15 ou 16, dans lequel les moyens d'entrée de la qualité du son sont en outre agencés de manière à permettre à un utilisateur d'introduire une pluralité de valeurs quantitatives de qualité du son, associées chacune respectivement à une qualité de son subjective différente définie par l'utilisateur.

18. Système de commande de la qualité de son selon la revendication 15 ou 16, dans lequel lesdits moyens d'entrée de la qualité du son sont en outre agencés de manière à permettre à un utilisateur d'introduire une pluralité de valeurs subjectives de qualités de son, chacune étant associée respectivement à une qualité de son subjective différente définie par l'utilisateur et chacune conformément à une échelle de qualité de son différente, ces échelles n'étant pas associées entre elles.

19. Système de commande de réglage de la qualité de son selon l'une quelconque des revendications 15 à 18, dans lequel lesdits moyens d'affichage de la qualité du son affichent au moins plus d'une échelle de qualité de son unidimensionnelle ou un plan bidimensionnel et un espace tridimensionnel constitués par des échelles de qualité de son de plus de deux catégories, ou à la fois les deux échelles mentionnées précédemment, et une valeur de qualité de son définie par l'utilisateur, introduite par lesdits moyens d'entrée de la qualité de son, sur une base en temps réel et simultanée.

20. Système de commande de la qualité de son selon les revendications 18 à 19, comprenant en outre:

une section de mémoire de la qualité de son pour enregistrer ladite valeur quantitative introduite de la qualité de son; et
des moyens de sélection de la qualité de son pour sélectionner ladite valeur de qualité de son quantitative enregistrée.

21. Système de commande de la qualité de son selon la revendication 20, comprenant en outre:

des moyens d'affichage d'une caractéristique de compensation pour afficher la caractéristique de compensation de fréquence produite par lesdits moyens d'extraction de la caractéristique de compensation.

22. Système de commande de la qualité du son agencé pour régler le spectre de fréquences d'un signal audio d'entrée pour obtenir une ou plusieurs qualités de son subjectives définies par l'utilisateur, lors de la reproduction du signal audio d'entrée dans un dispositif de reproduction du son, ledit système de réglage de la qualité du son comprenant:

des moyens (91) d'entrée d'une caractéristique de compensation pour introduire une caractéristique de compensation utilisée pour régler le signal audio d'entrée;
une section (92) de mémoire de caractéristiques de compensation pour enregistrer ladite caractéristique de compensation introduite;
des moyens (93) de sélection d'une caractéristique de compensation pour sélectionner une caractéristique de compensation enregistrée à partir de ladite section de mémoire;
des moyens (32) de réglage de la qualité de son pour recevoir un signal d'entrée audio et commander le spectre de fréquence dudit signal pour ajuster ledit signal;
des moyens de commande (38) pour commander les moyens de réglage de la qualité du son sur la base d'un signal de sortie desdits moyens de sélection de compensation;
des moyens (94) de calcul de la qualité du son pour calculer une ou plusieurs valeurs quantitatives de qualité de son indicatives respectivement des qualités de son subjectives définies par l'utilisateur sur la base de données de ladite caractéristique de compensation sélectionnée et moyennant l'utilisation d'une relation antagoniste quantitative précalculée entre une pluralité de grandeurs physiques caractéristiques, qui correspondent à une pluralité respective de bandes de fréquences dans une gamme prédéterminée de fréquences du dispositif de reproduction du son et une ou plusieurs valeurs quantitatives subjectives définies par l'utilisateur, qui correspondent chacune à une ou plusieurs qualités de son subjectives respectives définies par l'utilisateur, ladite relation antagoniste quantitative précalculée étant basée sur les coefficients de corrélation entre lesdites grandeurs physiques caractéristiques et lesdites valeurs quantitatives subjectives définies par l'utilisateur, et des moyens (95) d'affichage de la qualité du son pour afficher lesdites valeurs quantitatives calculées de qualité de son.

23. Système de commande de la qualité du son selon la revendication 22, dans lequel lesdits moyens d'entrée de caractéristiques de compensation incluent une forme de donnée compensant la caractéristique spectrale amplitude - fréquence du signal d'entrée.

24. Système de commande de la qualité du son selon la revendication 22 ou 23, dans lequel ladite relation antagoniste de type précalculé est une formule de régression, dans laquelle la qualité de son subjective définie par l'utilisateur est représentée sous la forme d'une unification linéaire de la pluralité de grandeurs physiques caractéristiques.

25. Système de commande de la qualité du son selon la revendication 24, dans lequel une échelle associée relative à l'une des qualités de son définies par l'utilisateur est graduée en plusieurs échelons et chaque échelon est pondéré par une valeur numérique en fonction du rang de graduation pour former une échelle des qualités de son;
ladite formule de régression utilisant une valeur relative à la qualité du son en tant que valeur de qualité de son quantitative.

26. Système de commande de la qualité de son selon la revendication 24 ou 25, dans lequel la caractéristique amplitude-fréquence de la caractéristique de compensation introduite à partir dudit moyen d'entrée de la caractéristique de compensation est utilisée en n bandes de fréquences, et une somme totale de la pression acoustique pour chacune des bandes de fréquences divisée par n est considérée comme le niveau de pression acoustique moyen;
ladite formule de régression traite au moins une des valeurs parmi les différences de pression acoustique pour chaque bande de fréquences par rapport audit niveau de pression acoustique moyen et sa valeur absolue en tant que grandeurs physiques caractéristiques.

27. Système de commande de la qualité de son selon l'une quelconque des revendications 22 à 26, dans lequel lesdits moyens d'affichage de la qualité de son affichent au moins plus d'une échelle d'évaluation unidimensionnelle ou un plan bidimensionnel et un espace tridimensionnel constitué par les échelles de qualités de son de plus de deux catégories, les deux échelles mentionnées précédemment, et une qualité de son introduite à partir desdits moyens d'entrée de la qualité de son, selon une base en temps réel et simultanée.

**28.** Procédé de modélisation de la qualité de son pour une modélisation quantitative d'une relation entre une ou plusieurs qualités de son subjectives définies par l'utilisateur et une pluralité de grandeurs physiques caractéristiques associées au son produit par la reproduction d'un signal audio d'entrée dans un dispositif de reproduction de son, ledit procédé comprenant les étapes consistant à:

reproduire le signal audio d'entrée dans le dispositif de reproduction de son;

modifier la pluralité de grandeurs physiques caractéristiques associées au son produit, lesdites grandeurs correspondant à une pluralité respective de bandes de fréquences dans une gamme prédéterminée de fréquences du second dispositif de reproduction;

évaluer des réponses d'auditeurs au son produit en utilisant une échelle quantitative de qualités de son pour obtenir une ou plusieurs valeurs quantitatives subjectives définies par l'utilisateur, chacune étant associée à une qualité de son subjective respective définie par l'utilisateur;

mettre en corrélation lesdites valeurs quantitatives subjectives définies par l'utilisateur avec lesdites grandeurs de ladite pluralité de grandeurs physiques caractéristiques pour chaque bande en vue d'obtenir une pluralité de coefficients de corrélation; et

calculer une relation antagoniste quantitative entre lesdites grandeurs physiques caractéristiques et lesdites valeurs quantitatives subjectives définies par l'utilisateur, sur la base de la pluralité calculée de coefficients de corrélation.

**29.** Procédé de modélisation de la qualité du son selon la revendication 28, selon lequel ladite relation antagoniste quantitative est une formule de régression obtenue par unification primaire linéaire de la pluralité de grandeurs physiques caractéristiques avec les valeurs quantitatives subjectives définies par l'utilisateur et répondant à la forme générale:

$$Z = a0 + a_1 X_i + a_2 X_2 + ... + a_1 X_i$$

dans laquelle Z est une valeur quantitative associée à la qualité de son subjective, $a_0$ à $a_i$ sont des coefficients, et $X_1$ à $X_i$ sont les grandeurs physiques caractéristiques respectivement pour chaque bande de fréquences.

Fig. 1

Fig. 2

1 0 : Model constituting means

Fig. 3

|  | | Very | Fairly | Rather | Neutral | Rather | Fairly | Very | |
|---|---|---|---|---|---|---|---|---|---|
| (1) | Lustrous | | | | | | | | Lackluster |
| (2) | Brilliant | | | | | | | | Dim |
| (3) | Poor | | | | | | | | Full |
| (4) | Flashy | | | | | | | | Quiet |
| (5) | Low-range distinct | | | | | | | | Low-range indistinct |
| (6) | Natural | | | | | | | | Unnatural |
| (7) | Rough | | | | | | | | Smooth |
| (8) | Sharp | | | | | | | | Dull |
| (9) | Strong | | | | | | | | Weak |
| (10) | Soft | | | | | | | | Loud |
| (11) | Well-balanced of frequency response | | | | | | | | Ill-balanced of frequency response |
| (12) | Dirty | | | | | | | | Beautiful |
| (13) | Clear | | | | | | | | Dirty |
| (14) | Thin | | | | | | | | Thick |
| (15) | High-range distinct | | | | | | | | High-range indistinct |
| (16) | Dull | | | | | | | | Distinct |

Fig. 4

EP 0 740 410 B1

(a) Correlation coefficient:
Deviation level and
Adjective of sound
quality

(b) Correlation coefficient:
Absolute value of
deviation level and
Adjective of sound quality

(1) +1 / -1 — Lackluster / Lustrous

(2) +1 / -1 — Dim / Brilliant

(3) +1 / -1 — Full / Poor

(4) +1 / -1 — Quiet / Flashy

(5) +1 / -1 — Low-range indistinct / Low-range distinct

(6) +1 / -1 — Unnatural / Natural

(7) +1 / -1 — Smooth / Rough

(8) +1 / -1 — Dull / Sharp

1 2 3 4 5 6 7 8 9 10 | 11 12 13 14 15 16 17 18 19 20
32 64 125 250 500 1K 2K 4K 8K 16K | 32 64 125 250 500 1K 2K 4K 8K 16K

frequency (Hz)

Fig. 5

| Sd. No. | Adjective of sound quality | Constant | Regression coefficient | | | | | | | | | |
|---|---|---|---|---|---|---|---|---|---|---|---|---|
| | | | 32 Hz | 63 Hz | 125 Hz | 250 Hz | 500 Hz | 1 K Hz | 2 K Hz | 4 K Hz | 8 K Hz | 16 KHz |
| 1 | Lustrous –Lackluster | 5.1425 | | .0651 | | .0264 | .0511 | | | -.0434 | -.0152 | -.0485 |
| 2 | Brilliant –Dim | 4.7816 | | .1182 | .1556 | .0523 | .1328 | | | -.0725 | -.0470 | -.0314 |
| 3 | Poor –Full | 2.9842 | | | .1577 | | | | -.0380 | -.0693 | -.0824 | |
| 4 | Flashy –Quiet | 3.8152 | | | .0246 | .1088 | .0698 | | -.0097 | -.1006 | -.0197 | |
| 5 | Low-range distinct –L-r indistinct | 4.7309 | | -.0782 | -.3090 | -.0440 | | .0576 | .0906 | .1223 | .1320 | |

EP 0 740 410 B1

Fig. 6

(a)

(b)

Fig. 7

2 0 A : Compensation characteristics extracting means

2 2 — Sound quality input means

2 1 — Compensation characteristic calculation means

Fig. 8

2 0 B : Compensation characteristics extracting means

2 5 B : Compensation characteristic setting means

2 1 — Compensation characteristic calculation means

2 2 — Sound quality input means

2 3 — Memory section

2 4 — Selection means

Fig. 9

20 C : Compensation characteristics
            extracting means

25 C Compensation characteristic
        setting means

21

Compensation characteristic
calculation means

23

Memory section

22

Sound quality
input means

24

Selection means

26

Interpolation
means

Fig. 10

31 Audio signal input means

32 Sound quality control means

33 Amplifier

34 Speaker

35 Sound quality input means

36 Sound quality display means

37 Compensation characteristics extracting means

38 Control means

Fig. 11

Fig. 12

Fig. 13

| Clarity | Fullness | Beauty |

Fig. 14

Fig. 15

71 Sound quality memory section
72 Sound quality selection means

Fig. 16

81 Compensation characteristic display means

Fig. 17

91 Compensation characteristic input means

92 Compensation characteristic memory section

93 Compensation characteristic selection means

94 Sound quality calculation means

95 Sound quality display means

Fig. 18

101 Audio signal input means

102 Graphic equalizer

103 Amplifier

104 Speaker

「PRIOR ART」